# FASCICULE DE BREVET EUROPEEN

(11) **EP 3 977 725 B1**
(45) Date de publication et mention de la délivrance du brevet: **03.07.2024**
(21) Numéro de dépôt: 20768085.1
(22) Date de dépôt: 06.05.2020
(51) Int. Cl.: G02B 30/28, H04N 13/32, H04N 13/307, H01L 27/146

(54) **DISPOSITIF OPTOÉLECTRONIQUE AYANT DES SYSTÈMES OPTIQUES DÉPLAÇABLES ENTRE DIFFÉRENTS PIXELS ET PROCÉDÉ DE CONTRÔLE**
ELEKTRONISCHES GERÄT MIT ÜBER VERSCHIEDENEN PIXELN VERSCHIEBBAREN OPTISCHEN SYSTEMEN
OPTOELECTRONIC DEVICE WITH OPTICAL SYSTEMS MOVABLE OVER DIFFERENT PIXELS AND CONTROL METHOD

(30) Priorité: 24.05.2019 FR 1905483
(43) Date de publication de la demande: 06.04.2022
(73) Titulaire: Aledia, 38130 Échirolles (FR)
(72) Inventeur: ROBIN, Ivan-Christophe, 38000 Grenoble (FR); JEANNIN, Olivier, 38000 Grenoble (FR); MAYER, Frédéric, 38500 VOIRON (FR)
(74) Mandataire: Germain Maureau
(86) Numéro de dépôt international: PCT/FR2020/050756
(87) Numéro de publication internationale: WO 2020/240106

(56) Documents cités:
- GB-A- 2 405 543
- US-A1- 2004 041 747
- US-A1- 2010 073 467
- US-A1- 2017 187 933
- TAI-HSIANG JEN ET AL: "Dynamic integral imaging display with electrically moving array lenslet technique using liquid crystal lens", OPTICS EXPRESS, vol. 23, no. 14, 7 juillet 2015 (2015-07-07), page 18415, XP055666631, DOI: 10.1364/OE.23.018415

## Description

### Domaine technique de l'invention

La présente invention concerne un dispositif optoélectronique configuré pour émettre de la lumière, notamment pour afficher une image, ou pour capter de la lumière, le dispositif optoélectronique comprenant :
- au moins un ensemble de pixels primaires où chaque pixel primaire est agencé sur une surface libre d'un substrat et comprend au moins un sous-pixel primaire chacun apte à émettre un faisceau lumineux primaire du côté opposé au substrat,
- au moins un ensemble de pixels secondaires où les pixels secondaires sont agencés sur la surface libre du substrat de façon alternée avec les pixels primaires de manière que chaque pixel primaire soit adjacent d'au moins un pixel secondaire et chaque pixel secondaire comprend au moins un sous-pixel secondaire apte à émettre un faisceau lumineux secondaire du côté opposé au substrat.

L'invention concerne également un système d'affichage d'image comprenant un tel dispositif optoélectronique.

L'invention concerne également un procédé de contrôle d'un tel dispositif optoélectronique.

L'invention trouve une application notamment dans les écrans d'affichage, les systèmes de projection d'images ou d'acquisition d'images, par exemple dans le cadre d'un écran de réalité virtuelle, d'un écran de téléphone intelligent ou d'un écran d'affichage notamment d'images tridimensionnelles, ou d'une caméra de prise d'images, notamment tridimensionnelles.

### Etat de la technique

Par « dispositif optoélectronique », il est ici entendu un dispositif adapté à effectuer la conversion d'un signal électrique en un rayonnement électromagnétique à émettre, notamment de la lumière, ou adapté pour capter de la lumière et la convertir en un signal électrique.

Il existe de tels dispositifs optoélectroniques comportant un ensemble de pixels aptes à émettre de la lumière pour afficher des images ou réciproquement aptes à capter la lumière extérieure dans le cadre de capture d'images.

Les pixels peuvent émettre des faisceaux lumineux le plus souvent multicolores grâce à des diodes électroluminescentes également connues sous l'acronyme LED pour « light-emitting diode » selon la terminologie anglo-saxonne consacrée, formées sur un substrat. Les diodes électroluminescentes émettent de façon générale un faisceau lumineux monochrome. Il est possible de conserver et d'utiliser directement la couleur de la lumière émise par les diodes électroluminescentes, ou bien de convertir la lumière de sorte à changer de couleurs, par exemple à l'aide de convertisseurs de couleurs. Pour faire un pixel multicolore, les diodes électroluminescentes émettant une même couleur sont donc regroupées au sein d'un sous-pixel qui émettra de fait un faisceau lumineux de la même couleur que les diodes électroluminescentes. Les autres sous-pixels destinés à émettre selon d'autres couleurs peuvent exploiter de tels convertisseurs de couleurs. Un pixel composé de plusieurs sous-pixels émettant des faisceaux lumineux de couleurs différentes peut donc paraître comme émettant un faisceau lumineux multicolore dont la couleur varie selon la sélection des sous-pixels actifs. Si les LEDs sont des nanofils ou des structures tridimensionnelles, chaque sous-pixel peut par exemple contenir jusqu'à 100000 diodes électroluminescentes à base de nanofils ou de structures tridimensionnelles de taille micrométrique ou nanométrique.

Il est connu que chaque diode électroluminescente comprenne un matériau actif exploitant ou non des puits quantiques, une portion semiconductrice dopée selon un premier type de dopage pour jouer le rôle de jonction dopée P et une portion semiconductrice dopée selon un deuxième type de dopage pour jouer le rôle de jonction dopée N.

Chaque diode électroluminescente peut être formée sur la base d'éléments semi-conducteurs tridimensionnels ou planaires, micrométriques voire nanométriques.

La tendance actuelle est de voir la définition des écrans ou des caméras augmenter, mais cela induit de réelles difficultés à vaincre. L'une d'elles est que les dimensions entre les sous-pixels et les dimensions de chaque sous-pixel deviennent micrométriques, voire nanométriques, et l'emploi de diodes électroluminescentes tridimensionnelles filaires devient inéluctable avec des diamètres de diodes électroluminescentes tridimensionnelles filaires toujours plus petits. Or, l'intensité lumineuse émise par les diodes électroluminescentes filaires nanométriques décroît drastiquement à mesure que la taille des diodes électroluminescentes filaires se réduit.

De plus, la lumière émise par une diode tridimensionnelle filaire n'est pas focalisée et présente au contraire une émission dans toutes les directions de l'espace. Pour des applications telles que la réalité augmentée ou la réalité virtuelle, la lumière émise par les micro afficheurs doit être injectée dans des guides d'onde. Pour avoir un couplage efficace avec des guides d'onde, la lumière émise par les écrans ou micro écrans utilisés doit être directionnelle. Aussi, dans les écrans pour la vision tridimensionnelle utilisant l'émission de différents angles de vue dans différentes directions (type d'écrans appelés « light field » en anglais), l'utilisation d'une optique couvrant plusieurs pixels pour envoyer différents angles de vue dans différentes directions fait chuter la résolution de l'écran.

Un inconvénient des solutions actuelles mises en oeuvre pour améliorer la directivité de ces faisceaux lumineux est que leur taille est limitée à la taille d'un pixel, ce qui réduit notamment l'efficacité lumineuse globale du dispositif.

Des applications peuvent également nécessiter que les faisceaux lumineux émis soient directionnels, ce qui est donc difficile à réaliser en utilisant uniquement des diodes électroluminescentes.

Une solution connue consiste à former des parois de confinement lumineux aptes à redresser le rayonnement lumineux émis par au moins une diode électroluminescente. Cette solution est décrite dans l'article "Dynamic intégral imaging display with moving array lenslet technique using liquid crystal lens" par Tai-Hsiang Jen et al.

Mais cette technique connue présente l'inconvénient de ne pas focaliser précisément la lumière émise par chaque diode électroluminescente. La direction de focalisation est en outre non ajustable dynamiquement.

Un autre inconvénient est qu'une quantité importante des faisceaux lumineux émis par les diodes électroluminescentes est absorbée par les solutions mises en oeuvre pour l'ajustement de leur directivité.

Une autre difficulté est que la focalisation de faisceaux lumineux émis par un sous-pixel devient de plus en plus difficile à mesure que la taille des sous-pixels devient micrométrique voire nanométrique.

Une autre difficulté réside dans l'affichage rémanent de ce qui s'apparente à une grille statique, due à l'espacement entre les pixels, lorsqu'un utilisateur regarde les images d'un dispositif optoélectronique ayant des moyens de focalisation statiques. Cet effet connu sous le nom anglais de « Screen door effect » ou « fixed pattern noise » est problématique car il induit des désagréments visuels pour l'utilisateur.

Dans le domaine de l'affichage d'images tridimensionnelles ne nécessitant pas de lunettes spécifiques, chaque angle de vue d'un même objet peut nécessiter l'utilisation d'un pixel. Donc dans une seule image tridimensionnelle de la sorte, un point de l'image tridimensionnelle affichée mobilise jusqu'à 25 pixels symbolisant chacun un angle de vue d'un objet de l'image à afficher. La résolution de l'image tridimensionnelle en est d'autant réduite drastiquement.

Les mêmes problématiques sont susceptibles de se poser pour un fonctionnement inversé dans le cadre d'un dispositif optoélectronique destiné à capter de la lumière.

En particulier, dans le domaine des caméras de prise d'images tridimensionnelles, pour capter un maximum d'angles de vue de l'objet de l'image, il est nécessaire de disposer de pixels aptes à capter de la lumière et de la transformer en un signal électrique pour chaque angle de vue. Il est alors nécessaire de disposer de plusieurs pixels pour une seule image tridimensionnelle, par exemple jusqu'à 25 pixels, ce qui réduit drastiquement la résolution de la caméra.

### Objet de l'invention

La présente invention a pour but de fournir un dispositif optoélectronique du type précité, qui réponde à tout ou partie des problèmes présentés ci-avant.

Notamment, un but est de fournir une solution répondant à au moins l'un des objectifs suivants :
- améliorer la focalisation et/ou la directivité de la lumière émise par chaque pixel ;
- améliorer l'efficacité lumineuse du dispositif optoélectronique ;
- réduire voire supprimer l'effet de grille optique ;
- améliorer la résolution d'affichage ou de capture d'images, notamment d'images tridimensionnelles.

Ce but peut être atteint grâce à un dispositif optoélectronique configuré pour émettre de la lumière, notamment pour afficher des images, ou pour capter de la lumière, le dispositif optoélectronique comprenant :
- au moins un ensemble {Ai} de pixels primaires (Aᵢ) où chaque pixel primaire (Aᵢ) est agencé sur une surface libre d'un substrat et comprend au moins un sous-pixel primaire A_{iβ} apte à émettre un faisceau lumineux primaire du côté opposé au substrat,
- au moins un ensemble {Bᵢ} de pixels secondaires Bᵢ où les pixels secondaires Bᵢ sont agencés sur la surface libre du substrat de façon alternée avec les pixels primaires Aᵢ de manière que chaque pixel primaire Aᵢ soit adjacent d'au moins un pixel secondaire Bᵢ et chaque pixel secondaire Bᵢ comprend au moins un sous-pixel secondaire B_{iβ} apte à émettre un faisceau lumineux secondaire du côté opposé au substrat,
- un ensemble {Cᵢ} de systèmes optiques Cᵢ où chaque système optique Cᵢ est agencé de sorte à pouvoir recouvrir, du côté opposé au substrat, à la fois l'intégralité d'un pixel Aᵢ, Bᵢ appartenant à l'un des ensembles {Ai}, {Bᵢ} de pixels choisi parmi l'ensemble {Ai} de pixels primaires Aᵢ et l'ensemble {Bi}de pixels secondaires Bᵢ et au moins une partie des sous-pixels A_{iβ}, B_{iβ} d'au moins l'un des pixels Aᵢ, Bᵢ adjacents appartenant à l'autre des ensembles {Ai}, {Bᵢ} de pixels, chaque système optique Cᵢ étant configuré pour agir optiquement sur tout ou partie des faisceaux lumineux susceptibles d'être émis par les sous-pixels A_{iβ}, B_{iβ} appartenant aux pixels Aᵢ, Bᵢ qu'il recouvre, le nombre total de pixels Aᵢ, Bᵢ des ensembles {Ai}, {Bᵢ} de pixels primaires et secondaires Aᵢ, Bᵢ étant supérieur ou égal à deux fois le nombre de systèmes optiques Cᵢ contenus dans l'ensemble {Cᵢ} de systèmes optiques Cᵢ,
- au moins un mécanisme de déplacement permettant d'appliquer un mouvement relatif entre l'ensemble {Cᵢ} de systèmes optiques Cᵢ et les ensembles {Aᵢ}, {Bᵢ} de pixels Aᵢ, Bᵢ selon une séquence prédéterminée.

Certains aspects préférés du dispositif optoélectronique mais non limitatifs sont les suivants.

Dans une mise en oeuvre du dispositif optoélectronique, ledit au moins un mécanisme de déplacement agit sur au moins un élément choisi dans le groupe comprenant l'ensemble {Cᵢ} de systèmes optiques Cᵢ, l'ensemble {Ai} de pixels primaires Aᵢ et l'ensemble {Bᵢ} de pixels secondaires Bᵢ, d'une manière telle que chaque système optique Cᵢ est susceptible d'occuper :
- une première position dans laquelle le système optique Cᵢ recouvre simultanément l'intégralité des sous-pixels primaires A_{iβ} de l'un des pixels primaires Aᵢ et une partie des sous-pixels secondaires B_{iβ} d'au moins l'un des pixels secondaires Bᵢ adjacents,
- une deuxième position dans laquelle le système optique Cᵢ recouvre simultanément l'intégralité des sous-pixels secondaires B_{iβ} de l'un des pixels secondaires Bᵢ et une partie des sous-pixels primaires A_{iβ} d'au moins l'un des pixels primaires Aᵢ adjacents, la séquence prédéterminée passant par une variation contrôlée entre la première position et la deuxième position.

Dans une mise en oeuvre du dispositif optoélectronique, chacun des pixels primaires et secondaires Aᵢ, Bᵢ est susceptible d'adopter une première configuration lumineuse dans laquelle l'intégralité des sous-pixels A_{iβ}, B_{iβ} qui le composent émettent un faisceau lumineux et dans lequel chaque système optique Cᵢ est susceptible d'occuper soit la première position lorsque le pixel primaire Aᵢ qu'il recouvre adopte la première configuration lumineuse, soit la deuxième position lorsque le pixel secondaire Bᵢ qu'il recouvre adopte la première configuration lumineuse.

Dans une mise en oeuvre du dispositif optoélectronique, ledit au moins un mécanisme de déplacement agit sur au moins un élément choisi dans le groupe comprenant l'ensemble {Cᵢ} de systèmes optiques Cᵢ, l'ensemble {Aᵢ} de pixels primaires Aᵢ et l'ensemble {Bᵢ} de pixels secondaires Bᵢ, d'une manière telle que chaque système optique Cᵢ est susceptible d'occuper une troisième position dans laquelle le système optique Cᵢ recouvre simultanément une partie des sous-pixels primaires A_{iβ} de l'un des pixels primaires Aᵢ et une partie des sous-pixels secondaires B_{iβ} d'au moins l'un des pixels secondaires Bᵢ adjacents, la séquence prédéterminée passant par une variation contrôlée entre la première position, la deuxième position et la troisième position.

Dans une mise en oeuvre du dispositif optoélectronique, chacun des pixels primaires et secondaires Aᵢ, Bᵢ est susceptible d'adopter une deuxième configuration lumineuse dans laquelle une partie des sous-pixels A_{iβ}, B_{iβ} qui le composent émettent un faisceau lumineux et dans lequel chaque système optique Cᵢ est susceptible d'occuper la troisième position lorsque au moins l'un des pixels primaires Aᵢ et au moins l'un des pixels secondaires Bᵢ qu'il recouvre en occupant la troisième position adoptent simultanément la deuxième configuration lumineuse, au moins l'un des sous-pixels primaires A_{iβ} et au moins l'un des sous-pixels secondaires B_{iβ} recouverts par le système optique Cᵢ occupant la troisième position émettant un faisceau lumineux.

Dans une mise en oeuvre du dispositif optoélectronique, la séquence prédéterminée assure une fréquence f pour les alternances entre la première configuration lumineuse et la deuxième configuration lumineuse, et pour les déplacements de chaque système optique Cᵢ de l'une parmi les première et deuxième positions vers la troisième position, exprimée en Hz, vérifiant la formule f≥24*n où n est le nombre de mouvements de translations possibles du système optique Cᵢ par ledit au moins un mécanisme de déplacement.

Dans une mise en oeuvre du dispositif optoélectronique, ledit au moins un mécanisme de déplacement comprend des actionneurs piézo-électriques et/ou des micro-actionneurs tels que des matériaux piézo-électriques et/ou des polymères électroactifs et/ou des alliages à mémoire de forme et/ou des actionneurs magnétiques.

Dans une mise en oeuvre du dispositif optoélectronique, chaque système optique Cᵢ comprend une lentille optique configurée de sorte à être traversée par au moins une partie des faisceaux lumineux susceptibles d'être émis par les sous-pixels primaires et secondaires A_{iβ}, B_{iβ} qu'elle recouvre en assurant leur transformation optique afin d'émettre en sortie un faisceau lumineux transformé au moins en partie rendu directionnel suivant une direction principale D1, D2.

Dans une mise en oeuvre du dispositif optoélectronique, le dispositif optoélectronique comprend au moins un élément de changement d'angle de collimation configuré pour agir sur au moins l'un des systèmes optiques Cᵢ de sorte à placer sélectivement sa lentille optique parmi une pluralité de configurations optiques distinctes, l'angle formé entre la direction principale D1, D2 et le susbtrat variant d'une configuration optique à une autre configuration optique.

Dans une mise en oeuvre du dispositif optoélectronique, l'élément de changement d'angle de collimation comprend des éléments piézo-électriques dans la lentille optique et/ou des micro-actionneurs tels que des matériaux piézo-électriques et/ou des polymères électroactifs et/ou des alliages à mémoire de forme et/ou des actionneurs magnétiques et/ou des cristaux liquides actionnables que la lentille optique incorpore.

Dans une mise en oeuvre du dispositif optoélectronique, au moins l'un parmi ledit au moins un mécanisme de déplacement et ledit au moins un élément de changement d'angle de collimation est configuré pour agir sur le système optique Cᵢ de façon à ce que le système optique Cᵢ se déplace au moins en partie de façon transversale à la surface libre du substrat et/ou au moins en partie de façon globalement parallèle à la surface libre du substrat.

Dans une mise en oeuvre du dispositif optoélectronique, au sein de l'ensemble {Cᵢ} de systèmes optiques Cᵢ, tous les systèmes optiques Cᵢ sont liés entre eux de sorte à former un ensemble unitaire monolithique au sein duquel chaque système optique Cᵢ est fixe par rapport à tous les autres systèmes optiques Cᵢ.

Dans un exemple du dispositif optoélectronique, la lentille optique est configurée pour délimiter une surface convexe recevant au moins un des faisceaux lumineux primaires ou au moins un des faisceaux lumineux secondaires et une surface plane par laquelle est émis le faisceau transformé.

Dans un exemple du dispositif optoélectronique, les faisceaux lumineux des sous-pixels primaires A_{iβ} composant le pixel primaire Aᵢ forment, ensemble, une surface émissive primaire dont une aire mesurée dans un plan parallèle à la surface libre du substrat est différente d'une aire représentant l'extension spatiale, mesurée dans le même plan parallèle à la surface libre du substrat, de l'ensemble des sous-pixels primaires A_{iβ} composant le pixel primaire Aᵢ, ou les faisceaux lumineux des sous-pixels primaires B_{iβ} composant le pixel secondaire Bᵢ forment, ensemble, une surface émissive primaire dont une aire mesurée dans le même plan parallèle à la surface libre du substrat est différente d'une aire représentant l'extension spatiale, mesurée dans le même plan parallèle à la surface libre du substrat, de l'ensemble des sous-pixels secondaires B_{iβ} composant le pixel secondaire Bᵢ.

Dans un exemple du dispositif optoélectronique, chaque lentille optique d'au moins deux systèmes optiques Cᵢ, Cᵢ₊₁ adjacents délimite au moins une forme polygonale et les lentilles optiques des deux systèmes optiques Cᵢ, Cᵢ₊₁ adjacents sont jointives selon au moins une face de la forme polygonale.

L'invention porte également sur la mise en oeuvre d'un système d'affichage d'image comprenant :
- au moins un tel dispositif optoélectronique,
- au moins un calculateur graphique apte à calculer des images à afficher par le dispositif optoélectronique et transmettre lesdites images à afficher au dispositif optoélectronique, le calculateur graphique étant configuré pour calculer au moins un ensemble d'images à afficher successivement comprenant n+1 images à afficher successivement,

l'ensemble d'images à afficher successivement comprenant une image à afficher comprenant des données relatives à l'ensemble {Ai} de pixels primaires Aᵢ et n images à afficher comprenant des données relatives aux n ensemble {Bᵢ} de pixels primaires Bᵢ correspondant à n déplacements de l'ensemble {Cᵢ} de systèmes optiques Cᵢ,
chaque image à afficher étant transmise au dispositif optoélectronique par le calculateur graphique de façon synchrone avec chaque déplacement de l'ensemble {Cᵢ} de systèmes optiques Cᵢ.

L'invention porte également sur la mise en oeuvre d'un procédé de contrôle d'un dispositif optoélectronique configuré pour émettre de la lumière, notamment pour afficher des images, ou pour capter de la lumière, dans lequel le dispositif optoélectronique comprend :
- au moins un ensemble {Aᵢ} de pixels primaires Aᵢ où chaque pixel primaire Aᵢ est agencé sur une surface libre d'un substrat et comprend au moins un sous-pixel primaire A_{iβ} apte à émettre un faisceau lumineux primaire du côté opposé au substrat,
- au moins un ensemble {Bᵢ} de pixels secondaires Bᵢ où les pixels secondaires Bᵢ sont agencés sur la surface libre du substrat de façon alternée avec les pixels primaires Aᵢ de manière que chaque pixel primaire Aᵢ soit adjacent d'au moins un pixel secondaire Bᵢ et chaque pixel secondaire Bᵢ comprend au moins un sous-pixel secondaire B_{iβ} apte à émettre un faisceau lumineux secondaire du côté opposé au substrat,

- un ensemble {Cᵢ} de systèmes optiques Cᵢ où chaque système optique Cᵢ est agencé de sorte à pouvoir recouvrir, du côté opposé au substrat, à la fois l'intégralité d'un pixel Aᵢ, Bᵢ appartenant à l'un des ensembles {Ai}, {Bᵢ} de pixels choisi parmi l'ensemble {Ai} de pixels primaires Aᵢ et l'ensemble {Bi}de pixels secondaires Bᵢ et au moins une partie des sous-pixels A_{iβ}, B_{iβ} d'au moins l'un des pixels Aᵢ, Bᵢ adjacents appartenant à l'autre des ensembles {Ai}, {Bᵢ} de pixels, chaque système optique Cᵢ étant configuré pour agir optiquement sur tout ou partie des faisceaux lumineux susceptibles d'être émis par les sous-pixels A_{iβ}, B_{iβ} appartenant aux pixels Aᵢ, Bᵢ qu'il recouvre, le nombre total de pixels Aᵢ, Bᵢ des ensembles {Aᵢ}, {Bᵢ} de pixels primaires et secondaires Aᵢ, Bᵢ étant supérieur ou égal à deux fois le nombre de systèmes optiques Cᵢ contenus dans l'ensemble {Cᵢ} de systèmes optiques Cᵢ,
- au moins un mécanisme de déplacement permettant d'appliquer un mouvement relatif séquentiel entre l'ensemble {Cᵢ} de systèmes optiques Cᵢ et les ensemble {Aᵢ}, {Bᵢ}) de pixels Aᵢ, Bᵢ selon une séquence prédéterminée,
le procédé de contrôle comprenant, pour la mise en oeuvre de ladite séquence prédéterminée, une phase répétée périodiquement dans le temps et comportant les étapes suivantes :
a) commander ledit au moins un mécanisme de déplacement d'une manière permettant de placer chaque système optique Cᵢ dans une première position dans laquelle le système optique Cᵢ recouvre simultanément l'intégralité des sous-pixels primaires A_{iβ} de l'un des pixels primaires Aᵢ et une partie des sous-pixels secondaires B_{iβ} d'au moins l'un des pixels secondaires Bᵢ adjacents ou dans une deuxième position dans laquelle le système optique Cᵢ recouvre simultanément l'intégralité des sous-pixels secondaires B_{iβ} de l'un des pixels secondaires Bᵢ et une partie des sous-pixels primaires A_{iβ} d'au moins l'un des pixels primaires Aᵢ adjacents,
b) agir sur le pixel primaire Aᵢ ou le pixel secondaire Bᵢ dont tous les sous-pixels A_{iβ}, B_{iβ} sont recouverts par le système optique Cᵢ à la suite de l'étape a) de sorte à le placer dans une première configuration lumineuse dans laquelle l'intégralité des sous-pixels A_{iβ}, B_{iβ} qui le composent émettent un faisceau lumineux,
c) commander ledit au moins un mécanisme de déplacement d'une manière permettant de déplacer chaque système optique Cᵢ pour le placer soit dans la deuxième position si le système optique Cᵢ occupait la première position à la suite de l'étape a), soit dans la première position si le système optique Cᵢ occupait la deuxième position à la suite de l'étape a), soit dans une troisième position dans laquelle le système optique Cᵢ recouvre simultanément une partie des sous-pixels primaires A_{iβ} de l'un des pixels primaires Aᵢ et une partie des sous-pixels secondaires B_{iβ} d'au moins l'un des pixels secondaires Bᵢ adjacents,
d) agir soit sur le pixel primaire Aᵢ ou le pixel secondaire Bᵢ dont tous les sous-pixels A_{iβ}, B_{iβ}) sont recouverts par le système optique Cᵢ à la suite de l'étape c) de sorte à le placer dans la première configuration lumineuse dans laquelle l'intégralité des sous-pixels A_{iβ}, B_{iβ} qui le composent émettent un faisceau lumineux, soit à la fois sur au moins un pixel primaire Aᵢ dont des sous-pixels primaires A_{iβ} sont recouverts par le système optique Cᵢ à la suite de l'étape c) de sorte à le placer dans une deuxième configuration lumineuse dans laquelle au moins l'un des sous-pixels primaires A_{iβ} recouverts par le système optique Cᵢ émet un faisceau lumineux et sur au moins un pixel secondaire Bᵢ dont des sous-pixels secondaires B_{iβ} sont recouverts par le système optique Cᵢ à la suite de l'étape c) de sorte à le placer dans une deuxième configuration lumineuse dans laquelle au moins l'un des sous-pixels secondaires B_{iβ} recouverts par le système optique Cᵢ émet un faisceau lumineux.

Dans une mise en oeuvre du procédé, chaque système optique Cᵢ comprend une lentille optique configurée de sorte à être traversée par au moins une partie des faisceaux lumineux susceptibles d'être émis par les sous-pixels primaires et secondaires A_{iβ}, B_{iβ} qu'elle recouvre en assurant leur transformation optique afin d'émettre en sortie un faisceau lumineux transformé au moins en partie rendu directionnel suivant une direction principale D1, D2 et dans lequel le dispositif optoélectronique comprend au moins un élément de changement d'angle de collimation configuré pour agir sur au moins l'un des systèmes optiques Cᵢ de sorte à placer sélectivement sa lentille optique parmi une pluralité de configurations optiques distinctes où l'angle formé entre la direction principale D1, D2 et le susbtrat varie d'une configuration optique à une autre configuration optique, le procédé de contrôle étant tel que la phase comprend une étape e), mise en oeuvre avant l'étape c), consistant à actionner l'élément de changement d'angle de collimation de manière à faire varier l'angle formé entre la direction principale D1, D2 et le susbtrat au moins une fois de sorte à placer la lentille optique successivement dans au moins deux configurations optiques distinctes.

### Description sommaire des dessins

D'autres aspects, buts, avantages et caractéristiques de l'invention apparaîtront mieux à la lecture de la description détaillée suivante des modes de réalisation préférés de celle-ci, donnée à titre d'exemple non limitatif, et faite en référence aux dessins annexés sur lesquels :
[Fig. 1] est une vue de dessus schématique de différentes configurations d'un ensemble {Ai} de pixels primaires Aᵢ, d'un ensemble {Bᵢ} de pixels secondaires Bᵢ et d'un ensemble {Cᵢ} de systèmes optiques (Cᵢ) d'un dispositif optoélectronique selon l'invention ;
[Fig. 2] est une vue schématique en coupe de différentes configurations d'un ensemble {Ai} de pixels primaires Aᵢ, d'un ensemble {Bᵢ} de pixels secondaires Bᵢ et d'un ensemble {Cᵢ} de systèmes optiques (Cᵢ) d'un dispositif optoélectronique selon l'invention ;
[Fig. 3] est une vue schématique en coupe de différentes configurations d'un ensemble {Cᵢ} de systèmes optiques (Cᵢ) d'un dispositif optoélectronique selon l'invention ;
[Fig. 4] est une vue de dessus schématique d'un exemple d'un ensemble {Cᵢ} de systèmes optiques (Cᵢ) d'un dispositif optoélectronique selon l'invention.

### EXPOSE DETAILLE DE MODES DE REALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation, exemples et variantes ne sont pas exclusifs les uns des autres et peuvent être combinés entre eux.

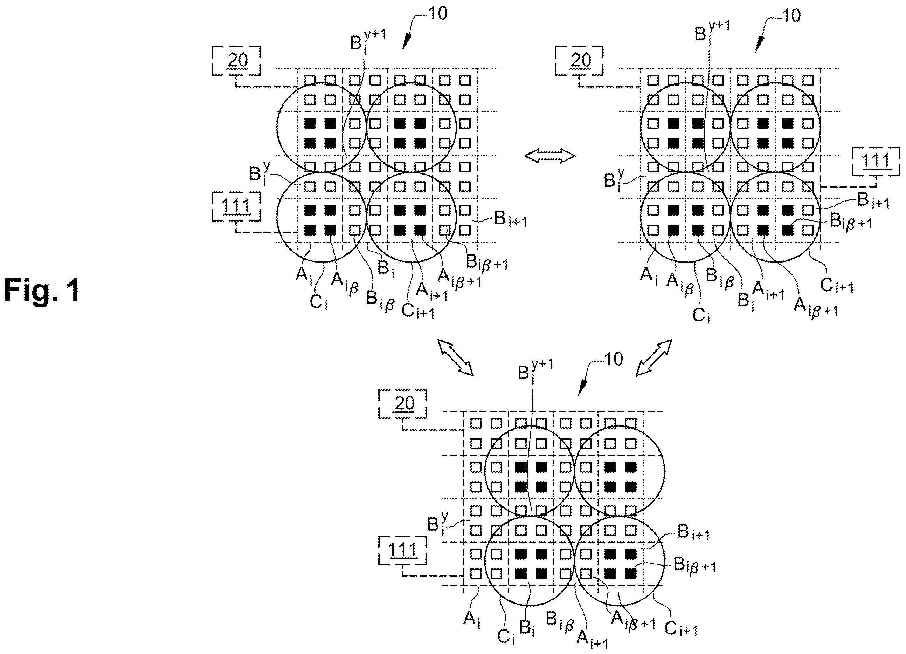

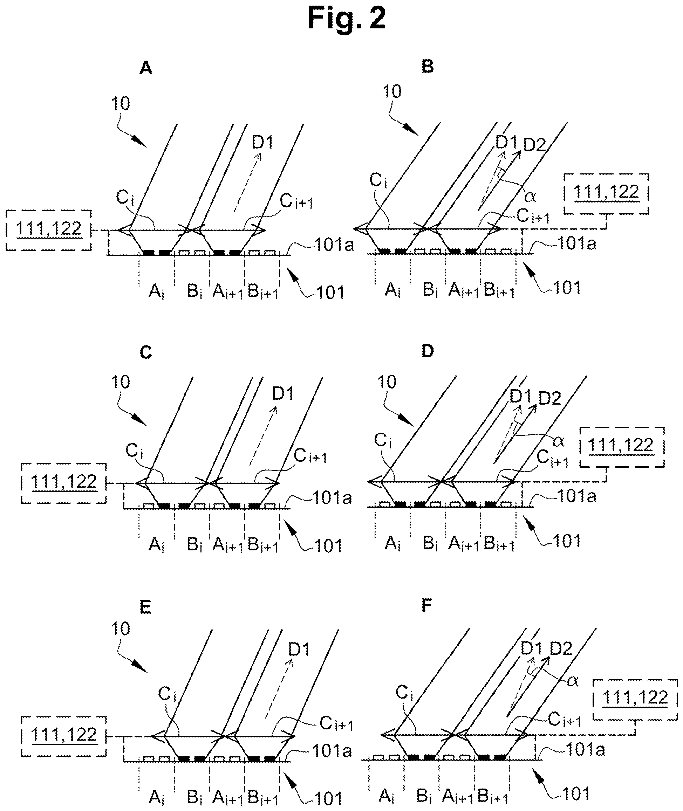

Comme illustré sur les figures 1 et 2, l'invention porte sur un dispositif optoélectronique 10 configuré pour émettre de la lumière, notamment pour afficher des images, ou pour capter de la lumière.

Le dispositif optoélectronique 10 comprend au moins un ensemble {Ai} de pixels primaires Aᵢ où chaque pixel primaire Aᵢ est agencé sur une surface 101a libre d'un substrat 101 et comprend au moins un sous-pixel primaire A_{iβ} apte à émettre un faisceau lumineux primaire du côté opposé au substrat 101. L'ensemble {Ai} peut être organisé de façon matricielle bidimensionnelle, voire d'une façon tridimensionnelle - non représentée-, où les lignes et colonnes sont indicées respectivement par exemple avec les indices i et y.

Le substrat 101 peut par exemple être formé dans un matériau semiconducteur mais également dans un matériau isolant ou conducteur. Le substrat 101 comprend également tout ou partie des connexions électroniques pour alimenter les pixels et les autres composants nécessaires au contrôle du dispositif optoélectronique. Le susbtrat 101 et les composants d'alimentation électronique étant bien connus de l'homme du métier ils ne seront pas décrits ici.

Par « sous-pixel » on entend un dispositif apte à émettre de la lumière ou capter de la lumière. Chaque sous-pixel peut par exemple comporter une ou plusieurs diodes électroluminescentes planes ou tridimensionnelles ayant des dimensions de l'ordre du millimètres jusqu'à quelques dizaines de nanomètres. Des sous-pixels à cristaux liquides sont par exemple également utilisables. Plusieurs sous-pixels aptes à générer chacun au moins une couleur différente de son ou ses voisins (en général rouge, vert, bleu, jaune) peuvent être agencés au sein d'un pixel afin que leur émission combinée forme une couleur résultant de la somme des couleurs de chaque sous-pixel et de leur intensité respective ou de la fréquence temporelle d'émission de chaque sous-pixel.

Le dispositif optoélectronique 10 comprend également au moins un ensemble {Bᵢ} de pixels secondaires Bᵢ. Les pixels secondaires Bᵢ sont agencés sur la surface 101a libre du substrat 101 de façon alternée avec les pixels primaires Aᵢ de manière que chaque pixel primaire Aᵢ soit adjacent d'au moins un pixel secondaire Bᵢ. Chaque pixel secondaire Bᵢ comprend au moins un sous-pixel secondaire B_{iβ} apte à émettre un faisceau lumineux secondaire du côté opposé au substrat 101. Les sous-pixels secondaires B_{iβ} sont de façon avantageuse formés de la même façon et sont de même nature que les sous-pixels primaires A_{iβ}.

Par « côté opposé au substrat » on entend, comme illustré sur la figure 2, que les faisceaux lumineux sont émis vers le haut dans l'espace libre non délimité par le substrat.

Le dispositif optoélectronique 10 comprend également un ensemble {Cᵢ} de systèmes optiques Cᵢ où chaque système optique Cᵢ est agencé, comme illustré par exemple sur les figures 1 et 2, de sorte à pouvoir recouvrir, du côté opposé au substrat 101, à la fois l'intégralité d'un pixel Aᵢ, Bᵢ appartenant à l'un des ensembles {Ai}, {Bᵢ} de pixels choisi parmi l'ensemble {Ai} de pixels primaires Aᵢ et l'ensemble {Bᵢ} de pixels secondaires Bᵢ et au moins une partie des sous-pixels A_{iβ}, B_{iβ} d'au moins l'un des pixels Aᵢ, Bᵢ adjacents appartenant à l'autre des ensembles {Ai}, {Bᵢ} de pixels.

Chaque système optique Cᵢ est configuré pour agir optiquement sur tout ou partie des faisceaux lumineux susceptibles d'être émis par les sous-pixels A_{iβ}, B_{iβ} appartenant aux pixels Aᵢ, Bᵢ qu'il recouvre, le nombre total de pixels Aᵢ, Bᵢ des ensembles {Ai}, {Bᵢ} de pixels primaires et secondaires Aᵢ, Bᵢ étant supérieur ou égal à deux fois le nombre de systèmes optiques Cᵢ contenus dans l'ensemble {Cᵢ} de systèmes optiques Cᵢ. Dans un exemple illustré sur la figure 1, un même système optique Cᵢ recouvre initialement tout un pixel Aᵢ , c'est-à-dire l'ensemble de ces sous-pixels A_{iβ}, ainsi que des sous-pixels B d'un pixel adjacent situé plus haut sur une colonne de pixels. Il recouvre également des sous-pixels B_{iβ} d'un pixel adjacent. Le système optique Cᵢ peut ainsi agir optiquement, dans un exemple, sur tous ces éléments de façon globale soit, dans un autre exemple comme expliqué plus après de façon séquentielle et/ou de façon individualisée à chaque sous-pixel concerné et séquentielle.

Dans un autre exemple, le système optique Cᵢ peut être plus étendu et recouvrir initialement plusieurs pixels consécutifs ou sous-pixels autant dans le sens des colonnes de la matrice de pixels que dans le sens des lignes.

Les différents systèmes optiques Cᵢ peuvent être adjacents comme décrit ici sur les figures 1 et 2 mais ils peuvent être également, dans un autre exemple, non adjacents, autrement dit non jointifs.

Dans un autre exemple, les systèmes optiques Cᵢ sont de formes circulaires.

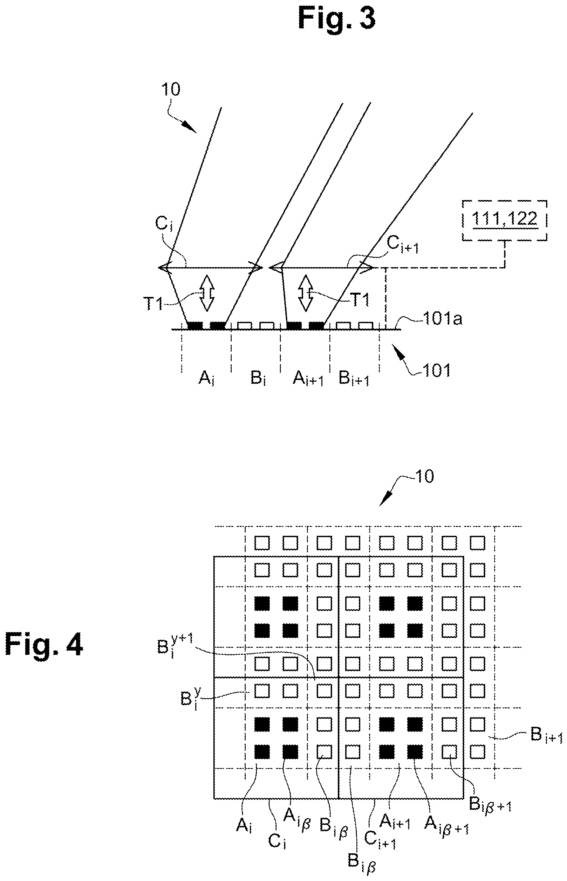

Dans un autre exemple illustré sur la figure 4, les systèmes optiques Cᵢ sont de forme polygonale par exemple carrée ou rectangulaire. Ceci permet de limiter les espaces laissés libres entre les système optique Cᵢ et cela permet de limiter les déplacements et augmenter la précision. Cet exemple permet également d'augmenter la luminosité du dispositif car un maximum de faisceaux lumineux émis est ainsi utilisé.

Dans un exemple, les systèmes optiques Cᵢ sont aptes à collimater le faisceau lumineux provenant de chaque sous-pixel. Cela permet avantageusement de fournir une lumière directionnelle en sortie du dispositif optoélectronique 10. Cet exemple permet également d'augmenter la luminosité car un maximum de la lumière émise par les sous-pixels est orientée dans la même direction.

Dans un autre exemple, les systèmes optiques Cᵢ sont aptes à focaliser le faisceau lumineux provenant de chaque sous-pixel. Cela peut être utile pour augmenter l'intensité en sortie du dispositif optoélectronique 10.

Suivant les exemples, le système optique Cᵢ peut être amené à effectuer par exemple plusieurs mouvements consécutifs afin de recouvrir l'ensemble des pixels et sous-pixels sur lesquels il doit agir optiquement.

Plus les systèmes optiques Cᵢ sont espacés plus ils doivent subir de mouvements pour couvrir l'ensemble des pixels et sous-pixels avec lesquels ils doivent interagir optiquement et plus ils doivent avoir une fréquence de déplacement élevée afin de pouvoir recouvrir de façon séquencée les différents pixels et sous-pixels concernés et éventuellement revenir à leur point de départ pour ensuite repartir pour une nouvelle séquence prédéterminée.

Le dispositif optoélectronique 10 comprend ainsi également au moins un mécanisme de déplacement 111 permettant d'appliquer un mouvement relatif entre l'ensemble {Cᵢ} de systèmes optiques Cᵢ et les ensemble {Aᵢ}, {Bᵢ} de pixels Aᵢ, Bᵢ selon une séquence prédéterminée.

Les déplacements relatifs de chaque système optique Cᵢ par rapport aux ensembles {Ai}, {Bᵢ} de pixels Aᵢ, Bᵢ peuvent être unis ou bidimensionnels selon les colonnes et les lignes de la matrice de pixels. Un système optique Cᵢ peut ainsi effectuer, par exemple, k² déplacements où k est le nombre de pixels différents à couvrir selon une matrice de pixels bidimensionnelle pendant une séquence prédéterminée.

Dans un exemple, au moins un mécanisme de déplacement 111 comprend des actionneurs piézo-électriques et/ou des micro-actionneurs tels que des matériaux piézo-électriques et/ou des polymères électroactifs et/ou des alliages à mémoire de forme et/ou des actionneurs magnétiques. Ces actionneurs peuvent être commandés de façon connue de l'homme du métier.

Un avantage d'un tel dispositif optoélectronique est que la lumière émise par les différents pixels n'est pas perdue car les faisceaux lumineux émis intéragissent en majorité avec les systèmes Cᵢ puisque ceux-ci sont plus larges que les pixels Aᵢ, Bᵢ.

Un tel dispositif optoélectronique 10 permet d'augmenter l'intensité lumineuse en sortie du dispositif optoélectronique 10. Un autre avantage est qu'il permet d'éliminer les lumières parasites et de limiter la consommation électrique.

Un tel dispositif peut par exemple être utilisé pour obtenir un dispositif optoélectronique émettant des faisceaux lumineux directionnels ce qui peut être avantageux pour augmenter la sécurité de visionnage ou encore permettre une utilisation dans les masques de réalité virtuelle ou de vision tridimensionnelle.

Dans un exemple de réalisation illustré sur les figures 1 et 2, ledit au moins un mécanisme de déplacement 111 agit sur au moins un élément choisi dans le groupe comprenant l'ensemble {Cᵢ} de systèmes optiques Cᵢ, l'ensemble {Aᵢ} de pixels primaires Aᵢ et l'ensemble {Bᵢ} de pixels secondaires Bᵢ, d'une manière telle que chaque système optique Cᵢ est susceptible d'occuper :
- une première position dans laquelle le système optique Cᵢ recouvre simultanément l'intégralité des sous-pixels primaires A_{iβ} de l'un des pixels primaires Aᵢ et une partie des sous-pixels secondaires B_{iβ} d'au moins l'un des pixels secondaires Bᵢ adjacents,
- une deuxième position dans laquelle le système optique Cᵢ recouvre simultanément l'intégralité des sous-pixels secondaires B_{iβ} de l'un des pixels secondaires Bᵢ et une partie des sous-pixels primaires A_{iβ} d'au moins l'un des pixels primaires Aᵢ adjacents, la séquence prédéterminée passant par une variation contrôlée entre la première position et la deuxième position.

La figure 2 montrent des exemples de sous-séquences par exemple A, C et E d'une séquence prédéterminée entre lesquelles le mouvement relatif de chaque système optique Cᵢ par rapport aux ensembles {Ai}, {Bᵢ} de pixels Aᵢ, Bᵢ permet aux différents systèmes optiques Cᵢ de recouvrir alternativement les pixels de l'ensemble {Aᵢ} puis un ou des sous-pixels A_{iβ} et un ou des sous-pixels B_{iβ} et ensuite les pixels de l'ensemble {Bᵢ} afin d'intéragir optiquement avec leur faisceau lumineux émis.

Un tel dispositif optoélectronique 10 permet d'augmenter l'intensité lumineuse. Un autre avantage est qu'il permet d'éliminer les lumières parasites et de limiter la consommation électrique.

Dans un exemple de mise en oeuvre du dispositif optoélectronique 10, chacun des pixels primaires et secondaires Aᵢ, Bᵢ est susceptible d'adopter une première configuration lumineuse dans laquelle l'intégralité des sous-pixels A_{iβ}, B_{iβ} qui le composent émettent un faisceau lumineux et dans lequel chaque système optique Cᵢ est susceptible d'occuper soit la première position lorsque le pixel primaire Aᵢ qu'il recouvre adopte la première configuration lumineuse, soit la deuxième position lorsque le pixel secondaire Bᵢ qu'il recouvre adopte la première configuration lumineuse.

Les images fantômes sont ainsi avantageusement éliminées car les pixels et/ou sous-pixels sont alternativement éteints. La consommation électrique est également diminuée.

Dans un exemple de mise en oeuvre illustré sur les figures 1 et 2, ledit au moins un mécanisme de déplacement 111 agit sur au moins un élément choisi dans le groupe comprenant l'ensemble {Cᵢ} de systèmes optiques Cᵢ, l'ensemble {Aᵢ} de pixels primaires Aᵢ et l'ensemble {Bᵢ} de pixels secondaires Bᵢ, d'une manière telle que chaque système optique Cᵢ est susceptible d'occuper une troisième position dans laquelle le système optique Cᵢ recouvre simultanément une partie des sous-pixels primaires A_{iβ} de l'un des pixels primaires Aᵢ et une partie des sous-pixels secondaires B_{iβ} d'au moins l'un des pixels secondaires Bᵢ adjacents, la séquence prédéterminée passant par une variation contrôlée entre la première position, la deuxième position et la troisième position. La consommation électrique sera ainsi avantageusement diminuée et la résolution des images augmentée notamment pour l'affichage d'images tridimensionnelles.

Dans un exemple de mise en oeuvre illustré sur la figure 1 et aux sous-séquences C et D de la figure 2, chacun des pixels primaires et secondaires Aᵢ, Bᵢ est susceptible d'adopter une deuxième configuration lumineuse dans laquelle une partie des sous-pixels A_{iβ}, B_{iβ} qui le composent émettent un faisceau lumineux et dans lequel chaque système optique Cᵢ est susceptible d'occuper la troisième position lorsque au moins l'un des pixels primaires Aᵢ et au moins l'un des pixels secondaires Bᵢ qu'il recouvre en occupant la troisième position adoptent simultanément la deuxième configuration lumineuse. Au moins l'un des sous-pixels primaires A_{iβ} et au moins l'un des sous-pixels secondaires B_{iβ} recouverts par le système optique Cᵢ occupant la troisième position, émettant un faisceau lumineux.

Dans un exemple, la séquence prédéterminée assure une fréquence f pour les alternances entre la première configuration lumineuse et la deuxième configuration lumineuse, et pour les déplacements de chaque système optique Cᵢ de l'une parmi les première et deuxième positions vers la troisième position, exprimée en Hz, vérifiant la formule f≥24*n où n est le nombre de mouvements de translations possibles du système optique Cᵢ par ledit au moins un mécanisme de déplacement 111. La perception lumineuse résultante dépendra du taux de recouvrement de chaque système Cᵢ par rapport à chaque sous-pixel ou pixel ainsi que de la nature de l'interaction optique entre les deux (par exemple collimation) mais aussi de la fréquence f. Par exemple si un système optique Cᵢ agit optiquement alternativement avec un sous-pixel bleu et un sous-pixel jaune adjacent avec une fréquence f≥24*2, il pourra en ressortir une couleur perçue comme un mélange des deux couleurs c'est-à-dire vert. Une telle fréquence f de déplacement permet avantageusement d'obtenir une résolution améliorée. En effet, les systèmes Cᵢ étant de taille supérieure aux pixels primaires ou secondaires, cela réduirait la résolution du dispositif optoélectronique 10. Mais avec une telle fréquence f, la résolution est augmentée car l'ensemble {Ai} de pixels primaires Aᵢ et l'ensemble {Bᵢ} de pixels secondaires Bᵢ et leurs sous-pixels sont ainsi tous recouverts alternativement de façon invisible par l'utilisateur pour qui la résolution est artificiellement élevée de part la persistence rétinienne.

Dans un exemple de mise en oeuvre du dispositif optoélectronique 10 illustré sur la figure 2, chaque système optique Cᵢ comprend une lentille optique configurée de sorte à être traversée par au moins une partie des faisceaux lumineux susceptibles d'être émis par les sous-pixels primaires et secondaires A_{iβ}, B_{iβ} qu'elle recouvre en assurant leur transformation optique afin d'émettre en sortie un faisceau lumineux transformé au moins en partie rendu directionnel suivant une direction principale D1, D2.

Dans un exemple de cette mise en oeuvre illustré sur la figure 2, le dispositif optoélectronique 10 comprend au moins un élément de changement d'angle de collimation 122 configuré pour agir sur au moins l'un des systèmes optiques Cᵢ de sorte à placer sélectivement sa lentille optique parmi une pluralité de configurations optiques distinctes. Ainsi, l'angle α formé entre la direction principale D1, D2 et le susbtrat 101 varie d'une configuration optique à une autre configuration optique. Cette configuration permet avantageusement de pouvoir créer un effet d'image tridimensionnelle avec un nombre de pixels ou sous-pixels limité. Dans un exemple de cette mise en oeuvre, le nombre de directions principales D1, D2, ...D25 est supérieur à 25 de par l'action de l'élément de changement d'angle de collimation 122. Un effet tridimensionnel artificiel de qualité est ainsi obtenu à partir potentiellement d'un pixel ou un groupe limité de sous-pixel. Ceci est différent de l'état de l'art où pour obtenir le même effet tridimensionnel, il faudrait mobiliser et illuminer successivement au moins 25 pixels ou sous-pixels ayant chacun une directionnalité d'émission différente pour pouvoir créer l'effet tridimensionnel. Donc cette mise en oeuvre du dispositif optoélectronique 10 est particulièrement avantageuse pour obtenir un effet visuel tridimensionnel de qualité pour l'utilisateur tout en gardant une résolution d'affichage préservée contrairement au cas de l'état de l'art où un pixel tridimensionnel est formé par au moins 25 sous-pixels ou 25 pixels directionnels formant chacun les directions D1 à D25.

Dans une autre mise en oeuvre du dispositif optoélectronique 10, l'élément de changement d'angle de collimation 122 comprend des éléments piézo-électriques dans la lentille optique et/ou des micro-actionneurs tels que des matériaux piézo-électriques et/ou des polymères électroactifs et/ou des alliages à mémoire de forme et/ou des actionneurs magnétiques et/ou des cristaux liquides actionnables que la lentille optique incorpore. L'homme du métier pourra utiliser ses connaissances pour mettre en oeuvre ces éléments.

Dans une autre mise en oeuvre du dispositif optoélectronique 10, illustrée sur la figure 3, au moins l'un parmi ledit au moins un mécanisme de déplacement 111 et ledit au moins un élément de changement d'angle de collimation 122 est configuré pour agir sur le système optique Cᵢ de façon à ce que le système optique Cᵢ se déplace, comme illustré sur la figure 3, au moins en partie de façon transversale à la surface libre 101a du substrat 101. Ceci est avantageux pour pouvoir changer la directionnalité ou la collimation ainsi que la focalisation ou le grossissement des faisceaux lumineux issus des pixels et/ou sous-pixels.

Dans une autre mise en oeuvre du dispositif optoélectronique 10, illustrée sur la figure 2 par le passage, par exemple entre les configurations A et B ou C et D ou encore E et F, par au moins un mécanisme de déplacement 111 et ledit au moins un élément de changement d'angle de collimation 122 est configuré pour agir sur le système optique Cᵢ de façon à ce que le système optique Cᵢ se déplace au moins en partie de façon globalement parallèle à la surface libre 101a du substrat 101. Cet exemple est avantageux car il permet de faire varier par la direction ou la focalisation d'un faisceau lumineux émis par un pixel ou un sous-pixel de façon précise et rapide tout en gardant une résolution élevée d'affichage.

Dans une autre mise en oeuvre du dispositif optoélectronique 10, illustré sur les figures 1 et 2, au sein de l'ensemble {Cᵢ} de systèmes optiques Cᵢ, tous les systèmes optiques Cᵢ sont liés entre eux de sorte à former un ensemble unitaire monolithique au sein duquel chaque système optique Cᵢ est fixe par rapport à tous les autres systèmes optiques Cᵢ. Cette mise en oeuvre est avantageuse car elle permet de limiter le nombre de mécanismes de déplacement 111 à utiliser pour déplacer l'ensemble {Cᵢ} de systèmes optiques Cᵢ. Un autre avantage est que cela permet de consommer moins d'énergie ainsi que d'augmenter la rapidité de mouvement de l'ensemble {Cᵢ} de systèmes optiques Cᵢ favorisant ainsi la fluidité d'affichage.

Dans un exemple du dispositif optoélectronique 10, la lentille optique est configurée pour délimiter une surface convexe recevant au moins un des faisceaux lumineux primaires ou au moins un des faisceaux lumineux secondaires et une surface plane par laquelle est émis le faisceau transformé.

Dans un exemple du dispositif optoélectronique 10, illustrée sur la figure 2, les faisceaux lumineux des sous-pixels primaires A_{iβ} composant le pixel primaire Aᵢ forment, ensemble, une surface émissive primaire dont une aire mesurée dans un plan parallèle à la surface 101a libre du substrat est différente d'une aire représentant l'extension spatiale, mesurée dans le même plan parallèle à la surface 101a libre du substrat, de l'ensemble des sous-pixels primaires A_{iβ} composant le pixel primaire Aᵢ. Il peut également en être de même pour les faisceaux lumineux des sous-pixels primaires B_{iβ} composant le pixel secondaire Bᵢ forment, ensemble, une surface émissive primaire dont une aire mesurée dans le même plan parallèle à la surface 101a libre du substrat est différente d'une aire représentant l'extension spatiale, mesurée dans le même plan parallèle à la surface 101a libre du substrat, de l'ensemble des sous-pixels secondaires B_{iβ} composant le pixel secondaire Bᵢ. Cette architecture est obtenue lorsque les sous-pixels émettent de façon non directionnelle. Dès lors l'utilisation des systèmes potiques Cᵢ est avantageuse pour agir optiquement sur ces faisceaux divergents et les faire converger ou les collimater par exemple ce qui permet d'améliorer l'intensité lumineuse par exemple selon une direction donnée.

Dans un exemple du dispositif optoélectronique 10 illustrée sur la figure 4, chaque lentille optique d'au moins deux systèmes optiques Cᵢ, Cᵢ₊₁ adjacents délimite au moins une forme polygonale et les lentilles optiques des deux systèmes optiques Cᵢ, Cᵢ₊₁ adjacents sont jointives selon au moins une face de la forme polygonale.

L'invention porte également sur un système d'affichage d'image comprenant :
- au moins un tel dispositif optoélectronique 10 ;
- au moins un calculateur graphique 20 apte à calculer des images à afficher par le dispositif optoélectronique 10 et transmettre lesdites images à afficher au dispositif optoélectronique 20, le calculateur graphique 20 étant configuré pour calculer au moins un ensemble d'images à afficher successivement comprenant n+1 images à afficher successivement, l'ensemble d'images à afficher successivement comprenant une image à afficher comprenant des données relatives à l'ensemble {Ai} de pixels primaires Aᵢ et n images à afficher comprenant des données relatives aux n ensemble {Bᵢ} de pixels primaires Bᵢ correspondant à n déplacements de l'ensemble {Cᵢ} de systèmes optiques Cᵢ, chaque image à afficher étant transmise au dispositif optoélectronique 10 par le calculateur graphique 20 de façon synchrone avec chaque déplacement de l'ensemble {Cᵢ} de systèmes optiques Cᵢ. Ce système d'affichage 20 permet avantageusement d'afficher des images en éliminant les images fantômes tout en gardant une résolution graphique élevée. Il permet également d'obtenir des images tridimensionnelles fluides avec une résolution graphique élevée sans images fantômes.

L'invention porte également sur un procédé de contrôle d'un dispositif optoélectronique 10 configuré pour émettre de la lumière, notamment pour afficher des images, ou pour capter de la lumière, dans lequel le dispositif optoélectronique 10 comprend :
- au moins un ensemble {Aᵢ} de pixels primaires Aᵢ où chaque pixel primaire Aᵢ est agencé sur une surface 101a libre d'un substrat 101 et comprend au moins un sous-pixel primaire A_{iβ} apte à émettre un faisceau lumineux primaire du côté opposé au substrat 101,
- au moins un ensemble {Bᵢ} de pixels secondaires Bᵢ où les pixels secondaires Bᵢ sont agencés sur la surface 101a libre du substrat 101 de façon alternée avec les pixels primaires Aᵢ de manière que chaque pixel primaire Aᵢ soit adjacent d'au moins un pixel secondaire Bᵢ et chaque pixel secondaire Bᵢ comprend au moins un sous-pixel secondaire B_{iβ} apte à émettre un faisceau lumineux secondaire du côté opposé au substrat 101,
- un ensemble {Cᵢ} de systèmes optiques Cᵢ où chaque système optique Cᵢ est agencé de sorte à pouvoir recouvrir, du côté opposé au substrat 101, à la fois l'intégralité d'un pixel Aᵢ, Bᵢ appartenant à l'un des ensembles {Ai}, {Bᵢ} de pixels choisi parmi l'ensemble {Ai} de pixels primaires Aᵢ et l'ensemble {Bᵢ} de pixels secondaires Bᵢ et au moins une partie des sous-pixels A_{iβ}, B_{iβ} d'au moins l'un des pixels Aᵢ, Bᵢ adjacents appartenant à l'autre des ensembles {Aᵢ}, {Bᵢ} de pixels, chaque système optique Cᵢ étant configuré pour agir optiquement sur tout ou partie des faisceaux lumineux susceptibles d'être émis par les sous-pixels A_{iβ}, B_{iβ} appartenant aux pixels Aᵢ, Bᵢ qu'il recouvre, le nombre total de pixels Aᵢ, Bᵢ des ensembles {Aᵢ}, {Bᵢ} de pixels primaires et secondaires Aᵢ, Bᵢ étant supérieur ou égal à deux fois le nombre de systèmes optiques Cᵢ contenus dans l'ensemble {Cᵢ} de systèmes optiques Cᵢ,
- au moins un mécanisme de déplacement 111 permettant d'appliquer un mouvement relatif séquentiel entre l'ensemble {Cᵢ} de systèmes optiques Cᵢ et les ensemble {Ai}, {Bᵢ} de pixels Aᵢ, Bᵢ selon une séquence prédéterminée.

Le procédé de contrôle comprend, pour la mise en oeuvre de ladite séquence prédéterminée, une phase répétée périodiquement dans le temps et comporte les étapes suivantes :
- a) commander ledit au moins un mécanisme de déplacement 111 d'une manière permettant de placer chaque système optique Cᵢ dans une première position dans laquelle le système optique Cᵢ recouvre simultanément l'intégralité des sous-pixels primaires A_{iβ} de l'un des pixels primaires Aᵢ et une partie des sous-pixels secondaires B_{iβ} d'au moins l'un des pixels secondaires Bᵢ adjacents ou dans une deuxième position dans laquelle le système optique Cᵢ recouvre simultanément l'intégralité des sous-pixels secondaires B_{iβ} de l'un des pixels secondaires Bᵢ et une partie des sous-pixels primaires A_{iβ} d'au moins l'un des pixels primaires Aᵢ adjacents,
- b) agir sur le pixel primaire Aᵢ ou le pixel secondaire Bᵢ dont tous les sous-pixels A_{iβ}, B_{iβ} sont recouverts par le système optique Cᵢ à la suite de l'étape a de sorte à le placer dans une première configuration lumineuse dans laquelle l'intégralité des sous-pixels A_{iβ}, B_{iβ} qui le composent émettent un faisceau lumineux,
- c) commander ledit au moins un mécanisme de déplacement 111 d'une manière permettant de déplacer chaque système optique Cᵢ pour le placer soit dans la deuxième position si le système optique Cᵢ occupait la première position à la suite de l'étape a, soit dans la première position si le système optique Cᵢ occupait la deuxième position à la suite de l'étape a, soit dans une troisième position dans laquelle le système optique Cᵢ recouvre simultanément une partie des sous-pixels primaires A_{iβ} de l'un des pixels primaires Aᵢ et une partie des sous-pixels secondaires B_{iβ} d'au moins l'un des pixels secondaires Bᵢ adjacents,
- d) agir soit sur le pixel primaire Aᵢ ou le pixel secondaire Bᵢ dont tous les sous-pixels A_{iβ}, B_{iβ} sont recouverts par le système optique Cᵢ à la suite de l'étape c de sorte à le placer dans la première configuration lumineuse dans laquelle l'intégralité des sous-pixels A_{iβ}, B_{iβ} qui le composent émettent un faisceau lumineux, soit à la fois sur au moins un pixel primaire Aᵢ dont des sous-pixels primaires A_{iβ} sont recouverts par le système optique Cᵢ à la suite de l'étape c) de sorte à le placer dans une deuxième configuration lumineuse dans laquelle au moins l'un des sous-pixels primaires A_{iβ} recouverts par le système optique Cᵢ émet un faisceau lumineux et sur au moins un pixel secondaire Bᵢ dont des sous-pixels secondaires B_{iβ} sont recouverts par le système optique Cᵢ à la suite de l'étape c) de sorte à le placer dans une deuxième configuration lumineuse dans laquelle au moins l'un des sous-pixels secondaires B_{iβ} recouverts par le système optique Cᵢ émet un faisceau lumineux.

Ce procédé est avantageux car il permet d'obtenir un affichage lumineux sans images fantômes.

Dans une exemple de mise en oeuvre du procédé, chaque système optique Cᵢ comprend une lentille optique configurée de sorte à être traversée par au moins une partie des faisceaux lumineux susceptibles d'être émis par les sous-pixels primaires et secondaires A_{iβ}, B_{iβ} qu'elle recouvre en assurant leur transformation optique afin d'émettre en sortie un faisceau lumineux transformé au moins en partie rendu directionnel suivant une direction principale D1, D2 et dans lequel le dispositif optoélectronique 10 comprend au moins un élément de changement d'angle de collimation 122 configuré pour agir sur au moins l'un des systèmes optiques Cᵢ de sorte à placer sélectivement sa lentille optique parmi une pluralité de configurations optiques distinctes où l'angle formé entre la direction principale D1, D2 et le substrat 101 varie d'une configuration optique à une autre configuration optique. Le procédé de contrôle est tel que la phase comprend une étape e), mise en oeuvre avant l'étape c), consistant à actionner l'élément de changement d'angle de collimation 122 de manière à faire varier l'angle formé entre la direction principale D1, D2 et le substrat 101 au moins une fois de sorte à placer la lentille optique successivement dans au moins deux configurations optiques distinctes.

Cet exemple est avantageux car il permet d'obtenir un affichage d'images tridimensionnelles ayant une résolution élevée.

## Revendications

1. Dispositif optoélectronique (10) configuré pour émettre de la lumière, notamment pour afficher des images, ou pour capter de la lumière, le dispositif optoélectronique (10) comprenant :
- au moins un ensemble {Ai} de pixels primaires (A;) où chaque pixel primaire (Aᵢ) est agencé sur une surface (101a) libre d'un substrat (101) et comprend au moins un sous-pixel primaire (A_{iβ}) apte à émettre un faisceau lumineux primaire du côté opposé au substrat (101),
- au moins un ensemble {Bᵢ} de pixels secondaires (Bᵢ) où les pixels secondaires (Bᵢ) sont agencés sur la surface (101a) libre du substrat (101) de façon alternée avec les pixels primaires (Aᵢ) de manière que chaque pixel primaire (Aᵢ) soit adjacent d'au moins un pixel secondaire (Bᵢ) et chaque pixel secondaire (Bᵢ) comprend au moins un sous-pixel secondaire (B_{iβ}) apte à émettre un faisceau lumineux secondaire du côté opposé au substrat (101),
- un ensemble {Cᵢ} de systèmes optiques (Cᵢ) où chaque système optique (Cᵢ) est agencé de sorte à pouvoir recouvrir, du côté opposé au substrat (101), à la fois l'intégralité d'un pixel (Aᵢ, Bᵢ) appartenant à l'un des ensembles ({Aᵢ}, {Bᵢ}) de pixels choisi parmi l'ensemble {Ai} de pixels primaires (Aᵢ) et l'ensemble {Bᵢ} de pixels secondaires (Bᵢ) et au moins une partie des sous-pixels (A_{iβ}, B_{iβ}) d'au moins l'un des pixels (Aᵢ, Bᵢ) adjacents appartenant à l'autre des ensembles ({Aᵢ}, {Bi}) de pixels, chaque système optique (Cᵢ) étant configuré pour agir optiquement sur tout ou partie des faisceaux lumineux susceptibles d'être émis par les sous-pixels (A_{iβ}, B_{iβ}) appartenant aux pixels (Aᵢ, Bᵢ) qu'il recouvre, le nombre total de pixels (Aᵢ, Bᵢ) des ensembles ({Ai}, {Bi}) de pixels primaires et secondaires (Aᵢ, Bᵢ) étant supérieur ou égal à deux fois le nombre de systèmes optiques (Cᵢ) contenus dans l'ensemble {Cᵢ} de systèmes optiques (Cᵢ),
- au moins un mécanisme de déplacement (111) permettant d'appliquer un mouvement relatif entre l'ensemble {Cᵢ} de systèmes optiques (Cᵢ) et les ensemble ({Ai}, {Bi}) de pixels (Aᵢ, Bᵢ) selon une séquence prédéterminée.

2. Dispositif optoélectronique (10) selon la revendication 1, dans lequel ledit au moins un mécanisme de déplacement (111) agit sur au moins un élément choisi dans le groupe comprenant l'ensemble {Cᵢ} de systèmes optiques (Cᵢ), l'ensemble {Ai} de pixels primaires (Aᵢ) et l'ensemble {Bᵢ} de pixels secondaires (Bᵢ), d'une manière telle que chaque système optique (Cᵢ) est susceptible d'occuper :
- une première position dans laquelle le système optique (Cᵢ) recouvre simultanément l'intégralité des sous-pixels primaires (A_{iβ}) de l'un des pixels primaires (Aᵢ) et une partie des sous-pixels secondaires (B_{iβ}) d'au moins l'un des pixels secondaires (Bᵢ) adjacents,
- une deuxième position dans laquelle le système optique (Cᵢ) recouvre simultanément l'intégralité des sous-pixels secondaires (B_{iβ}) de l'un des pixels secondaires (Bᵢ) et une partie des sous-pixels primaires (A_{iβ}) d'au moins l'un des pixels primaires (Aᵢ) adjacents, la séquence prédéterminée passant par une variation contrôlée entre la première position et la deuxième position.

3. Dispositif optoélectronique (10) selon la revendication 2, dans lequel chacun des pixels primaires et secondaires (Aᵢ, Bᵢ) est susceptible d'adopter une première configuration lumineuse dans laquelle l'intégralité des sous-pixels (A_{iβ}, B_{iβ}) qui le composent émettent un faisceau lumineux et dans lequel chaque système optique (Cᵢ) est susceptible d'occuper soit la première position lorsque le pixel primaire (A;) qu'il recouvre adopte la première configuration lumineuse, soit la deuxième position lorsque le pixel secondaire (Bᵢ) qu'il recouvre adopte la première configuration lumineuse.

4. Dispositif optoélectronique (10) selon l'une des revendications 2 ou 3, dans lequel ledit au moins un mécanisme de déplacement (111) agit sur au moins un élément choisi dans le groupe comprenant l'ensemble {Cᵢ} de systèmes optiques (Cᵢ), l'ensemble {Aᵢ} de pixels primaires (Aᵢ) et l'ensemble {Bᵢ} de pixels secondaires (Bᵢ), d'une manière telle que chaque système optique (Cᵢ) est susceptible d'occuper une troisième position dans laquelle le système optique (Cᵢ) recouvre simultanément une partie des sous-pixels primaires (A_{iβ}) de l'un des pixels primaires (Aᵢ) et une partie des sous-pixels secondaires (B_{iβ}) d'au moins l'un des pixels secondaires (Bᵢ) adjacents, la séquence prédéterminée passant par une variation contrôlée entre la première position, la deuxième position et la troisième position.

5. Dispositif optoélectronique (10) selon la revendication 4, dans lequel chacun des pixels primaires et secondaires (Aᵢ, Bᵢ) est susceptible d'adopter une deuxième configuration lumineuse dans laquelle une partie des sous-pixels (A_{iβ}, B_{iβ}) qui le composent émettent un faisceau lumineux et dans lequel chaque système optique (Cᵢ) est susceptible d'occuper la troisième position lorsque au moins l'un des pixels primaires (Aᵢ) et au moins l'un des pixels secondaires (Bᵢ) qu'il recouvre en occupant la troisième position adoptent simultanément la deuxième configuration lumineuse, au moins l'un des sous-pixels primaires (A_{iβ}) et au moins l'un des sous-pixels secondaires (B_{iβ}) recouverts par le système optique (Cᵢ) occupant la troisième position émettant un faisceau lumineux.

6. Dispositif optoélectronique (10) selon la revendication 5, dans lequel la séquence prédéterminée assure une fréquence f pour les alternances entre la première configuration lumineuse et la deuxième configuration lumineuse, et pour les déplacements de chaque système optique (Cᵢ) de l'une parmi les première et deuxième positions vers la troisième position, exprimée en Hz, vérifiant la formule f≥24*n où n est le nombre de mouvements de translations possibles du système optique (Cᵢ) par ledit au moins un mécanisme de déplacement (111).

7. Dispositif optoélectronique (10) selon l'une des revendications 1 à 6, dans lequel ledit au moins un mécanisme de déplacement (111) comprend des actionneurs piézo-électriques et/ou des micro-actionneurs tels que des matériaux piézo-électriques et/ou des polymères électroactifs et/ou des alliages à mémoire de forme et/ou des actionneurs magnétiques.

8. Dispositif optoélectronique (10) selon l'une quelconque des revendications 1 à 7, dans lequel chaque système optique (Cᵢ) comprend une lentille optique configurée de sorte à être traversée par au moins une partie des faisceaux lumineux susceptibles d'être émis par les sous-pixels primaires et secondaires (A_{iβ}, B_{iβ}) qu'elle recouvre en assurant leur transformation optique afin d'émettre en sortie un faisceau lumineux transformé au moins en partie rendu directionnel suivant une direction principale (D1, D2).

9. Dispositif optoélectronique (10) selon la revendication 8, dans lequel le dispositif optoélectronique (10) comprend au moins un élément de changement d'angle de collimation (122) configuré pour agir sur au moins l'un des systèmes optiques (Cᵢ) de sorte à placer sélectivement sa lentille optique parmi une pluralité de configurations optiques distinctes, l'angle formé entre la direction principale (D1, D2) et le susbtrat (101) variant d'une configuration optique à une autre configuration optique.

10. Dispositif optoélectronique (10) selon la revendication 9, dans lequel l'élément de changement d'angle de collimation (122) comprend des éléments piézo-électriques dans la lentille optique et/ou des micro-actionneurs tels que des matériaux piézo-électriques et/ou des polymères électroactifs et/ou des alliages à mémoire de forme et/ou des actionneurs magnétiques et/ou des cristaux liquides actionnables que la lentille optique incorpore.

11. Dispositif optoélectronique (10) selon l'une des revendications 9 ou 10, dans lequel au moins l'un parmi ledit au moins un mécanisme de déplacement (111) et ledit au moins un élément de changement d'angle de collimation (122) est configuré pour agir sur le système optique (Cᵢ) de façon à ce que le système optique (Cᵢ) se déplace :
- au moins en partie de façon transversale à la surface libre (101a) du substrat (101) ; et/ou
- au moins en partie de façon globalement parallèle à la surface libre (101a) du substrat (101).

12. Dispositif optoélectronique (10) selon l'une quelconque des revendications 1 à 11, dans lequel au sein de l'ensemble {Cᵢ} de systèmes optiques (Cᵢ), tous les systèmes optiques (Cᵢ) sont liés entre eux de sorte à former un ensemble unitaire monolithique au sein duquel chaque système optique (Cᵢ) est fixe par rapport à tous les autres systèmes optiques (Cᵢ).

13. Système d'affichage d'image comprenant :
- au moins un dispositif optoélectronique (10) selon la revendication 6 et l'une des revendications 7 à 12,
- au moins un calculateur graphique (20) apte à calculer des images à afficher par le dispositif optoélectronique (10) et transmettre lesdites images à afficher au dispositif optoélectronique (20),
le calculateur graphique (20) étant configuré pour calculer au moins un ensemble d'images à afficher successivement comprenant n+1 images à afficher successivement, l'ensemble d'images à afficher successivement comprenant une image à afficher comprenant des données relatives à l'ensemble {A;} de pixels primaires (A;) et n images à afficher comprenant des données relatives aux n ensemble {B;} de pixels primaires (Bᵢ) correspondant à n déplacements de l'ensemble {Cᵢ} de systèmes optiques (Cᵢ),
chaque image à afficher étant transmise au dispositif optoélectronique (10) par le calculateur graphique (20) de façon synchrone avec chaque déplacement de l'ensemble {Cᵢ} de systèmes optiques (Cᵢ).

14. Procédé de contrôle d'un dispositif optoélectronique (10) configuré pour émettre de la lumière, notamment pour afficher des images, ou pour capter de la lumière, dans lequel le dispositif optoélectronique (10) comprend :
- au moins un ensemble {Ai} de pixels primaires (A;) où chaque pixel primaire (Aᵢ) est agencé sur une surface (101a) libre d'un substrat (101) et comprend au moins un sous-pixel primaire (A_{iβ}) apte à émettre un faisceau lumineux primaire du côté opposé au substrat (101),
- au moins un ensemble {Bᵢ} de pixels secondaires (Bᵢ) où les pixels secondaires (Bᵢ) sont agencés sur la surface (101a) libre du substrat (101) de façon alternée avec les pixels primaires (Aᵢ) de manière que chaque pixel primaire (Aᵢ) soit adjacent d'au moins un pixel secondaire (Bᵢ) et chaque pixel secondaire (Bᵢ) comprend au moins un sous-pixel secondaire (B_{iβ}) apte à émettre un faisceau lumineux secondaire du côté opposé au substrat (101),
- un ensemble {Cᵢ} de systèmes optiques (Cᵢ) où chaque système optique (Cᵢ) est agencé de sorte à pouvoir recouvrir, du côté opposé au substrat (101), à la fois l'intégralité d'un pixel (Aᵢ, Bᵢ) appartenant à l'un des ensembles ({Aᵢ}, {Bᵢ}) de pixels choisi parmi l'ensemble {Aᵢ} de pixels primaires (Aᵢ) et l'ensemble {Bᵢ} de pixels secondaires (Bᵢ) et au moins une partie des sous-pixels (A_{iβ}, B_{iβ}) d'au moins l'un des pixels (Aᵢ, Bᵢ) adjacents appartenant à l'autre des ensembles ({Ai}, {Bᵢ}) de pixels, chaque système optique (Cᵢ) étant configuré pour agir optiquement sur tout ou partie des faisceaux lumineux susceptibles d'être émis par les sous-pixels (A_{iβ}, B_{iβ}) appartenant aux pixels (Aᵢ, Bᵢ) qu'il recouvre, le nombre total de pixels (Aᵢ, Bᵢ) des ensembles ({Ai}, {Bᵢ}) de pixels primaires et secondaires (Aᵢ, Bᵢ) étant supérieur ou égal à deux fois le nombre de systèmes optiques (Cᵢ) contenus dans l'ensemble {Cᵢ} de systèmes optiques (Cᵢ),
- au moins un mécanisme de déplacement (111) permettant d'appliquer un mouvement relatif séquentiel entre l'ensemble {Cᵢ} de systèmes optiques (Cᵢ) et les ensemble ({Aᵢ}, {Bᵢ}) de pixels (Aᵢ, Bᵢ) selon une séquence prédéterminée,
le procédé de contrôle comprenant, pour la mise en oeuvre de ladite séquence prédéterminée, une phase répétée périodiquement dans le temps et comportant les étapes suivantes :
a) commander ledit au moins un mécanisme de déplacement (111) d'une manière permettant de placer chaque système optique (Cᵢ) dans une première position dans laquelle le système optique (Cᵢ) recouvre simultanément l'intégralité des sous-pixels primaires (A_{iβ}) de l'un des pixels primaires (Aᵢ) et une partie des sous-pixels secondaires (B_{iβ}) d'au moins l'un des pixels secondaires (Bᵢ) adjacents ou dans une deuxième position dans laquelle le système optique (Cᵢ) recouvre simultanément l'intégralité des sous-pixels secondaires (B_{iβ}) de l'un des pixels secondaires (Bᵢ) et une partie des sous-pixels primaires (A_{iβ}) d'au moins l'un des pixels primaires (Aᵢ) adjacents,
b) agir sur le pixel primaire (Aᵢ) ou le pixel secondaire (Bᵢ) dont tous les sous-pixels (A_{iβ}, B_{iβ}) sont recouverts par le système optique (Cᵢ) à la suite de l'étape a) de sorte à le placer dans une première configuration lumineuse dans laquelle l'intégralité des sous-pixels (A_{iβ}, B_{iβ}) qui le composent émettent un faisceau lumineux,
c) commander ledit au moins un mécanisme de déplacement (111) d'une manière permettant de déplacer chaque système optique (Cᵢ) pour le placer soit dans la deuxième position si le système optique (Cᵢ) occupait la première position à la suite de l'étape a), soit dans la première position si le système optique (Cᵢ) occupait la deuxième position à la suite de l'étape a), soit dans une troisième position dans laquelle le système optique (Cᵢ) recouvre simultanément une partie des sous-pixels primaires (A_{iβ}) de l'un des pixels primaires (Aᵢ) et une partie des sous-pixels secondaires (B_{iβ}) d'au moins l'un des pixels secondaires (Bᵢ) adjacents,
d) agir soit sur le pixel primaire (Aᵢ) ou le pixel secondaire (Bᵢ) dont tous les sous-pixels (A_{iβ}, B_{iβ}) sont recouverts par le système optique (Cᵢ) à la suite de l'étape c) de sorte à le placer dans la première configuration lumineuse dans laquelle l'intégralité des sous-pixels (A_{iβ}, B_{iβ}) qui le composent émettent un faisceau lumineux, soit à la fois sur au moins un pixel primaire (A;) dont des sous-pixels primaires (A_{iβ}) sont recouverts par le système optique (Cᵢ) à la suite de l'étape c) de sorte à le placer dans une deuxième configuration lumineuse dans laquelle au moins l'un des sous-pixels primaires (A_{iβ}) recouverts par le système optique (Cᵢ) émet un faisceau lumineux et sur au moins un pixel secondaire (Bᵢ) dont des sous-pixels secondaires (B_{iβ}) sont recouverts par le système optique (Cᵢ) à la suite de l'étape c) de sorte à le placer dans une deuxième configuration lumineuse dans laquelle au moins l'un des sous-pixels secondaires (B_{iβ}) recouverts par le système optique (Cᵢ) émet un faisceau lumineux.

15. Procédé de contrôle selon la revendication 14, dans lequel chaque système optique (Cᵢ) comprend une lentille optique configurée de sorte à être traversée par au moins une partie des faisceaux lumineux susceptibles d'être émis par les sous-pixels primaires et secondaires (A_{iβ}, B_{iβ}) qu'elle recouvre en assurant leur transformation optique afin d'émettre en sortie un faisceau lumineux transformé au moins en partie rendu directionnel suivant une direction principale (D1, D2) et dans lequel le dispositif optoélectronique (10) comprend au moins un élément de changement d'angle de collimation (122) configuré pour agir sur au moins l'un des systèmes optiques (Cᵢ) de sorte à placer sélectivement sa lentille optique parmi une pluralité de configurations optiques distinctes où l'angle formé entre la direction principale (D1, D2) et le susbtrat (101) varie d'une configuration optique à une autre configuration optique, le procédé de contrôle étant tel que la phase comprend une étape e), mise en oeuvre avant l'étape c), consistant à actionner l'élément de changement d'angle de collimation (122) de manière à faire varier l'angle formé entre la direction principale (D1, D2) et le susbtrat (101) au moins une fois de sorte à placer la lentille optique successivement dans au moins deux configurations optiques distinctes.

## Patentansprüche

1. Optoelektronische Vorrichtung (10), die dazu konfiguriert ist, Licht zu emittieren, insbesondere Bilder anzuzeigen, oder Licht einzufangen, wobei die optoelektronische Vorrichtung (10) Folgendes umfasst:
- mindestens einen Satz {Ai} primärer Pixel (Aᵢ), wobei jedes primäre Pixel (Aᵢ) auf einer freien Oberfläche (101a) eines Substrats (101) angeordnet ist und mindestens ein primäres Teilpixel (A_{iβ}) umfasst, das dazu ausgelegt ist, einen primären Lichtstrahl auf der dem Substrat (101) gegenüberliegenden Seite zu emittieren,
- mindestens einen Satz {Bᵢ} sekundärer Pixel (Bᵢ), wobei die sekundären Pixel (Bᵢ) abwechselnd mit den primären Pixeln (Aᵢ) auf der freien Oberfläche (101a) des Substrats (101) angeordnet sind, so dass jedes primäre Pixel (Aᵢ) mindestens einem sekundären Pixel (Bᵢ) benachbart ist und jedes sekundäre Pixel (Bᵢ) mindestens ein sekundäres Teilpixel (B_{iβ}) umfasst, das dazu ausgelegt ist, einen sekundären Lichtstrahl auf der dem Substrat (101) gegenüberliegenden Seite zu emittieren,
- einen Satz {Cᵢ} optischer Systeme (Cᵢ), wobei jedes optische System (Cᵢ) so angeordnet ist, dass es auf der dem Substrat (101) gegenüberliegenden Seite sowohl die Gesamtheit eines Pixels (Aᵢ, Bᵢ), das zu einem der Sätze ({Ai}, {Bi}) von Pixeln gehört, die aus dem Satz {Aᵢ} primärer Pixel (Aᵢ) und dem Satz {Bᵢ} sekundärer Pixel (Bᵢ) ausgewählt sind, als auch mindestens einen Teil der Teilpixel (A_{iβ}, B_{iβ}) von mindestens einem der benachbarten Pixel (Aᵢ, Bᵢ), die zu dem anderen der Sätze ({Ai}, {Bi}) von Pixeln gehören, abdecken kann, wobei jedes optische System (Cᵢ) dazu konfiguriert ist, optisch auf alle oder einen Teil der Lichtstrahlen einzuwirken, die von den Teilpixeln (A_{iβ}, B_{iβ}) emittiert werden können, die zu den Pixeln (Aᵢ, Bᵢ) gehören, die es abdeckt, wobei die Gesamtanzahl der Pixel (Aᵢ, Bᵢ) der Sätze ({Ai}, {Bi}) primärer und sekundärer Pixel (Aᵢ, Bᵢ) größer oder gleich dem Doppelten der Anzahl optischer Systeme (Cᵢ) ist, die in dem Satz {Cᵢ} optischer Systeme (Cᵢ) enthalten sind,
- mindestens einen Verschiebungsmechanismus (111), der es ermöglicht, eine relative Bewegung zwischen dem Satz {Ci} optischer Systeme (Cᵢ) und den Sätzen ({Ai}, {Bi}) von Pixeln (Aᵢ, Bᵢ) in einer vorbestimmten Reihenfolge auszuüben.

2. Optoelektronische Vorrichtung (10) nach Anspruch 1, wobei der mindestens eine Verschiebungsmechanismus (111) auf mindestens ein Element, das aus der Gruppe ausgewählt ist, die den Satz {Cᵢ} optischer Systeme (Cᵢ), den Satz {Aᵢ} primärer Pixel (Aᵢ) und den Satz {Bᵢ} sekundärer Pixel (Bᵢ) umfasst, derart einwirkt, dass jedes optische System (Cᵢ) Folgendes einnehmen kann:
- eine erste Position, in der das optische System (Cᵢ) gleichzeitig die Gesamtheit der primären Teilpixel (A_{iβ}) eines der primären Pixel (Aᵢ) und einen Teil der sekundären Teilpixel (B_{iβ}) von mindestens einem der benachbarten sekundären Pixel (Bᵢ) abdeckt,
- eine zweite Position, in der das optische System (Cᵢ) gleichzeitig die Gesamtheit der sekundären Teilpixel (B_{iβ}) eines der sekundären Pixel (Bᵢ) und einen Teil der primären Teilpixel (A_{iβ}) von mindestens einem der benachbarten primären Pixel (Aᵢ) abdeckt, wobei die vorbestimmte Reihenfolge eine kontrollierte Variation zwischen der ersten Position und der zweiten Position durchläuft.

3. Optoelektronische Vorrichtung (10) nach Anspruch 2, wobei jedes der primären und sekundären Pixel (Aᵢ, Bᵢ) eine erste Lichtkonfiguration annehmen kann, in der die Gesamtheit der Teilpixel (A_{iβ}, B_{iβ}), aus denen sie besteht, einen Lichtstrahl emittiert, und wobei jedes optische System (Cᵢ) entweder die erste Position, wenn das primäre Pixel (Aᵢ), das es abdeckt, die erste Lichtkonfiguration annimmt, oder die zweite Position, wenn das sekundäre Pixel (Bᵢ), das es abdeckt, die erste Lichtkonfiguration annimmt, einnehmen kann.

4. Optoelektronische Vorrichtung (10) nach einem der Ansprüche 2 oder 3, wobei der mindestens eine Verschiebungsmechanismus (111) auf mindestens ein Element, das aus der Gruppe ausgewählt ist, die den Satz {Cᵢ} optischer Systeme (Cᵢ), den Satz {Aᵢ} primärer Pixel (Aᵢ) und den Satz {Bᵢ} sekundärer Pixel (Bᵢ) umfasst, derart einwirkt, dass jedes optische System (Cᵢ) eine dritte Position einnehmen kann, in der das optische System (Cᵢ) gleichzeitig einen Teil der primären Teilpixel (A_{iβ}) eines der primären Pixel (Aᵢ) und einen Teil der sekundären Teilpixel (B_{iβ}) von mindestens einem der benachbarten sekundären Pixel (Bᵢ) abdeckt, wobei die vorbestimmte Reihenfolge eine kontrollierte Variation zwischen der ersten Position, der zweiten Position und der dritten Position durchläuft.

5. Optoelektronische Vorrichtung (10) nach Anspruch 4, wobei jedes der primären und sekundären Pixel (Aᵢ, Bᵢ) eine zweite Lichtkonfiguration annehmen kann, in der ein Teil der Teilpixel (A_{iβ}, B_{iβ}), aus denen sie bestehen, einen Lichtstrahl emittiert, und wobei jedes optische System (Cᵢ) die dritte Position einnehmen kann, wenn mindestens eines der primären Pixel (Aᵢ) und mindestens eines der sekundären Pixel (Bᵢ), die es bedeckt, indem es die dritte Position einnimmt, gleichzeitig die zweite Lichtkonfiguration einnehmen, wobei mindestens eines der primären Teilpixel (A_{iβ}) und mindestens eines der sekundären Teilpixel (B_{iβ}), die von dem optischen System (Cᵢ) bedeckt werden, das die dritte Position einnimmt, einen Lichtstrahl emittieren.

6. Optoelektronische Vorrichtung (10) nach Anspruch 5, wobei die vorbestimmte Reihenfolge eine Frequenz f für die Wechsel zwischen der ersten Lichtkonfiguration und der zweiten Lichtkonfiguration und für die Verschiebungen jedes optischen Systems (Cᵢ) von der ersten oder der zweiten Position in Richtung der dritten Position, ausgedrückt in Hz, sicherstellt, die die Formel f≥24*n erfüllt, wobei n die Anzahl der möglichen Translationsbewegungen des optischen Systems (Cᵢ) durch den mindestens einen Verschiebungsmechanismus (111) ist.

7. Optoelektronische Vorrichtung (10) nach einem der Ansprüche 1 bis 6, wobei der mindestens eine Verschiebungsmechanismus (111) piezoelektrische Aktuatoren und/oder Mikro-Aktuatoren wie piezoelektrische Materialien und/oder elektroaktive Polymere und/oder Formgedächtnislegierungen und/oder magnetische Aktuatoren umfasst.

8. Optoelektronische Vorrichtung (10) nach einem der Ansprüche 1 bis 7, wobei jedes optische System (Cᵢ) eine optische Linse umfasst, die derart konfiguriert ist, dass sie von mindestens einem Teil der Lichtstrahlen durchquert wird, die von den primären und sekundären Teilpixeln (A_{iβ}, B_{iβ}), die sie abdeckt, emittiert werden können, indem ihre optische Transformation sichergestellt wird, um am Ausgang einen transformierten Lichtstrahl zu emittieren, der dazu gebracht wird, mindestens teilweise einer Hauptrichtung (D1, D2) zu folgen.

9. Optoelektronische Vorrichtung (10) nach Anspruch 8, wobei die optoelektronische Vorrichtung (10) mindestens ein Kollimationswinkeländerungselement (122) umfasst, das dazu konfiguriert ist, auf mindestens eines der optischen Systeme (Cᵢ) derart einzuwirken, dass seine optische Linse selektiv in eine Vielzahl von unterschiedlichen optischen Konfigurationen gebracht wird, wobei sich der zwischen der Hauptrichtung (D1, D2) und dem Substrat (101) gebildete Winkel von einer optischen Konfiguration zu einer anderen optischen Konfiguration verändert.

10. Optoelektronische Vorrichtung (10) nach Anspruch 9, wobei das Kollimationswinkeländerungselement (122) piezoelektrische Elemente in der optischen Linse und/oder Mikro-Aktuatoren wie piezoelektrische Materialien und/oder elektroaktive Polymere und/oder Formgedächtnislegierungen und/oder magnetische Aktuatoren und/oder betätigbare Flüssigkristalle, die die optische Linse enthält, umfasst.

11. Optoelektronische Vorrichtung (10) nach einem der Ansprüche 9 oder 10, wobei der mindestens eine Verschiebungsmechanismus (111) und/oder das mindestens eine Kollimationswinkeländerungselement (122) dazu konfiguriert ist, derart auf das optische System (Cᵢ) einzuwirken, dass das optische System (Cᵢ) sich wie folgt verschiebt:
- mindestens teilweise quer zur freien Oberfläche (101a) des Substrats (101); und/oder
- mindestens teilweise im Allgemeinen parallel zur freien Oberfläche (101a) des Substrats (101).

12. Optoelektronische Vorrichtung (10) nach einem der Ansprüche 1 bis 11, wobei innerhalb des Satzes {Cᵢ} optischer Systeme (Cᵢ) alle optischen Systeme (Cᵢ) miteinander verbunden sind, um eine monolithische einheitliche Baugruppe zu bilden, in der jedes optische System (Cᵢ) in Bezug auf alle anderen optischen Systeme (Cᵢ) fixiert ist.

13. Bildanzeigesystem, das Folgendes umfasst:
- mindestens eine optoelektronische Vorrichtung (10) nach Anspruch 6 und einem der Ansprüche 7 bis 12,
- mindestens einen Grafikrechner (20), der dazu ausgelegt ist, die von der optoelektronischen Vorrichtung (10) anzuzeigenden Bilder zu berechnen und die anzuzeigenden Bilder an die optoelektronische Vorrichtung (20) zu übertragen,
wobei der Grafikrechner (20) dazu konfiguriert ist, mindestens einen Satz von nacheinander anzuzeigenden Bildern zu berechnen, der n+1 nacheinander anzuzeigende Bilder umfasst, wobei der Satz von nacheinander anzuzeigenden Bildern ein anzuzeigendes Bild, das Daten umfasst, die sich auf den Satz {Aᵢ} primärer Pixel (Aᵢ) beziehen, und n anzuzeigende Bilder umfasst, die Daten umfassen, die sich auf die n Sätze {Bᵢ} primärer Pixel (Bᵢ) beziehen, die n Verschiebungen des Satzes {Cᵢ} optischer Systeme (Cᵢ) entsprechen,
wobei jedes anzuzeigende Bild vom Grafikrechner (20) synchron mit jeder Verschiebung des Satzes {Cᵢ} optischer Systeme (Cᵢ) an die optoelektronische Vorrichtung (10) übertragen wird.

14. Verfahren zum Steuern einer optoelektronischen Vorrichtung (10), die dazu konfiguriert ist, Licht zu emittieren, insbesondere Bilder anzuzeigen, oder Licht einzufangen, wobei die optoelektronische Vorrichtung (10) Folgendes umfasst:
- mindestens einen Satz {Aᵢ} primärer Pixel (Aᵢ), wobei jedes primäre Pixel (Aᵢ) auf einer freien Oberfläche (101a) eines Substrats (101) angeordnet ist und mindestens ein primäres Teilpixel (A_{iβ}) umfasst, das dazu ausgelegt ist, einen primären Lichtstrahl auf der dem Substrat (101) gegenüberliegenden Seite zu emittieren,
- mindestens einen Satz {Bᵢ} sekundärer Pixel (Bᵢ), wobei die sekundären Pixel (Bᵢ) abwechselnd mit den primären Pixeln (Aᵢ) auf der freien Oberfläche (101a) des Substrats (101) angeordnet sind, so dass jedes primäre Pixel (Aᵢ) mindestens einem sekundären Pixel (Bᵢ) benachbart ist und jedes sekundäre Pixel (Bᵢ) mindestens ein sekundäres Teilpixel (B_{iβ}) umfasst, das dazu ausgelegt ist, einen sekundären Lichtstrahl auf der dem Substrat (101) gegenüberliegenden Seite zu emittieren,
- einen Satz {Cᵢ} optischer Systeme (Cᵢ), wobei jedes optische System (Cᵢ) so angeordnet ist, dass es auf der dem Substrat (101) gegenüberliegenden Seite sowohl die Gesamtheit eines Pixels (Aᵢ, Bᵢ), das zu einem der Sätze ({Ai}, {Bi}) von Pixeln gehört, die aus dem Satz {Aᵢ} primärer Pixel (Aᵢ) und dem Satz {Bᵢ} sekundärer Pixel (Bᵢ) ausgewählt sind, als auch mindestens einen Teil der Teilpixel (A_{iβ}, B_{iβ}) von mindestens einem der benachbarten Pixel (Aᵢ, Bᵢ), die zu dem anderen der Sätze ({Ai}, {Bi}) von Pixeln gehören, abdecken kann, wobei jedes optische System (Cᵢ) dazu konfiguriert ist, optisch auf alle oder einen Teil der Lichtstrahlen einzuwirken, die von den Teilpixeln (A_{iβ}, B_{iβ}) emittiert werden können, die zu den Pixeln (Aᵢ, Bᵢ) gehören, die es abdeckt, wobei die Gesamtanzahl der Pixel (Aᵢ, Bᵢ) der Sätze ({Ai}, {Bi}) primärer und sekundärer Pixel (Aᵢ, Bᵢ) größer oder gleich dem Doppelten der Anzahl optischer Systeme (Cᵢ) ist, die in dem Satz {Cᵢ} optischer Systeme (Cᵢ) enthalten sind,
- mindestens einen Verschiebungsmechanismus (111), der es ermöglicht, eine relative Bewegung zwischen dem Satz {Cᵢ} optischer Systeme (Cᵢ) und den Sätzen ({Ai}, {Bi}) von Pixeln (Aᵢ, Bᵢ) in einer vorbestimmten Reihenfolge auszuüben,
wobei das Steuerverfahren zum Durchführen der vorbestimmten Reihenfolge eine periodisch über die Zeit wiederholte Phase sowie die folgenden Schritte umfasst:
a) Steuern des mindestens einen Verschiebungsmechanismus (111) in einer Weise, die es ermöglicht, jedes optische System (Cᵢ) in eine erste Position, in der das optische System (Cᵢ) gleichzeitig die Gesamtheit der primären Teilpixel (A_{iβ}) eines der primären Pixel (Aᵢ) und einen Teil der sekundären Teilpixel (B_{iβ}) von mindestens einem der benachbarten sekundären Pixel (Bᵢ) abdeckt, oder eine zweite Position zu bringen, in der das optische System (Cᵢ) gleichzeitig die Gesamtheit der sekundären Teilpixel (B_{iβ}) eines der sekundären Pixel (Bᵢ) und einen Teil der primären Teilpixel (A_{iβ}) von mindestens einem der benachbarten primären Pixel (Aᵢ) abdeckt,
b) Einwirken auf das primäre Pixel (Aᵢ) oder das sekundäre Pixel (Bᵢ), dessen Teilpixel (A_{iβ}, B_{iβ}) alle durch das optische System (Cᵢ) nach Schritt a) abgedeckt werden, um es in eine erste Lichtkonfiguration zu bringen, in der die Gesamtheit der Teilpixel (A_{iβ}, B_{iβ}), aus denen sie besteht, einen Lichtstrahl emittiert,
c) Steuern des mindestens einen Verschiebungsmechanismus (111) in einer Weise, die es ermöglicht, jedes optische System (Cᵢ) zu verschieben, um es entweder in die zweite Position zu bringen, wenn das optische System (Cᵢ) nach Schritt a) die erste Position einnimmt, oder in die erste Position, wenn das optische System (Cᵢ) nach Schritt a) die zweite Position einnimmt, oder in eine dritten Position, in der das optische System (Cᵢ) gleichzeitig einen Teil der primären Teilpixel (A_{iβ}) eines der primären Pixel (Aᵢ) und einen Teil der sekundären Teilpixel (B_{iβ}) von mindestens einem der benachbarten sekundären Pixel (Bᵢ) abdeckt, und
d) Einwirken entweder auf das primäre Pixel (Aᵢ) oder das sekundäre Pixel (Bᵢ), dessen gesamte Teilpixel (A_{iβ}, B_{iβ}) vom optischen System (Cᵢ) nach Schritt c) abgedeckt werden, um es in die erste Lichtkonfiguration zu bringen, in der die Gesamtheit der Teilpixel (A_{iβ}, B_{iβ}), aus denen es besteht, einen Lichtstrahl emittiert, oder gleichzeitig auf mindestens ein primäres Pixel (Aᵢ), dessen primäre Teilpixel (A_{iβ}) nach Schritt c) von dem optischen System (Cᵢ) abgedeckt werden, um es in eine zweite Lichtkonfiguration zu bringen, in der mindestens eines der primären Teilpixel (A_{iβ}), dessen sekundäre Teilpixel (B_{iβ}) nach Schritt c) von dem optischen System (Cᵢ) abgedeckt werden, einen Lichtstrahl emittiert, und auf mindestens ein sekundäres Pixel (Bᵢ), dessen sekundäre Teilpixel (B_{iβ}) nach Schritt c) von dem optischen System (Ci) abgedeckt werden, um es in eine zweite Lichtkonfiguration zu bringen, in der das mindestens eine der sekundären Teilpixel (B_{iβ}), die durch das optische System (Cᵢ) abgedeckt werden, einen Lichtstrahl emittiert.

15. Steuerverfahren nach Anspruch 14, wobei jedes optische System (Cᵢ) eine optische Linse umfasst, die derart konfiguriert ist, dass sie von mindestens einem Teil der Lichtstrahlen durchquert wird, die von den primären und sekundären Teilpixeln (A_{iβ}, B_{iβ}), die sie abdeckt, emittiert werden können, indem ihre optische Transformation sichergestellt wird, um am Ausgang einen transformierten Lichtstrahl zu emittieren, der dazu gebracht wird, mindestens teilweise einer Hauptrichtung (D1, D2) zu folgen, und wobei die optoelektronische Vorrichtung (10) mindestens ein Kollimationswinkeländerungselement (122) umfasst, das dazu konfiguriert ist, auf mindestens eines der optischen Systeme (Cᵢ) derart einzuwirken, dass seine optische Linse selektiv in eine Vielzahl von unterschiedlichen optischen Konfigurationen gebracht wird, wobei sich der zwischen der Hauptrichtung (D1, D2) und dem Substrat (101) gebildete Winkel von einer optischen Konfiguration zu einer anderen optischen Konfiguration verändert, wobei das Steuerverfahren derart ist, dass die Phase einen Schritt e) umfasst, der vor Schritt c) durchgeführt wird und darin besteht, das Kollimationswinkeländerungselement (122) zu betätigen, um den zwischen der Hauptrichtung (D1, D2) und dem Substrat (101) gebildeten Winkel mindestens einmal derart zu verändern, dass die optische Linse nacheinander in mindestens zwei unterschiedliche optische Konfigurationen gebracht wird.

## Claims

1. An optoelectronic device (10) configured to emit light, in particular to display images, or to capture light, the optoelectronic device (10) comprising:
- at least one set {Ai} of primary pixels (Aᵢ) where each primary pixel (Aᵢ) is arranged on a free surface (101a) of a substrate (101) and comprises at least one primary sub-pixel (A_{iβ}) capable of emitting a primary light beam on the side opposite to the substrate (101),
- at least one set {Bᵢ} of secondary pixels (Bᵢ) where the secondary pixels (Bᵢ) are arranged on the free surface (101a) of the substrate (101) alternately with the primary pixels (Aᵢ) so that each primary pixel (Aᵢ) is adjacent to at least one secondary pixel (Bᵢ) and each secondary pixel (Bᵢ) comprises at least one secondary sub-pixel (B_{iβ}) capable of emitting a secondary light beam on the side opposite to the substrate (101),
- a set {Cᵢ} of optical systems (Cᵢ) where each optical system (Cᵢ) is arranged so as to be able to cover, on the side opposite to the substrate (101), both the entirety of a pixel (Aᵢ, Bᵢ) belonging to one of the sets ({Ai}, {Bi}) of pixels selected from the set {Ai} of primary pixels (Aᵢ) and the set {Bᵢ} of secondary pixels (Bᵢ) and at least part of sub-pixels (A_{iβ}, B_{iβ}) of at least one of the adjacent pixels (Aᵢ, Bᵢ) belonging to the other of the sets ({Ai}, {Bi}) of pixels, each optical system (Cᵢ) being configured to act optically on all or part of the light beams likely to be emitted by the sub-pixels (A_{iβ}, B_{iβ}) belonging to the pixels (Aᵢ Bᵢ) that it covers, the total number of pixels (Aᵢ, Bᵢ) of the sets ({Ai}, {Bi}) of primary and secondary pixels (Aᵢ, Bᵢ) being greater or equal to twice the number of optical systems (Cᵢ) contained in the set {Cᵢ} of optical systems (Cᵢ),
- at least one displacement mechanism (111) making it possible to apply a relative movement between the set {Cᵢ} of optical systems (Cᵢ) and the sets ({Ai}, {Bi}) of pixels (Aᵢ, Bᵢ) in a predetermined sequence.

2. The optoelectronic device (10) according to claim 1, wherein said at least one displacement mechanism (111) acts on at least one element selected from the group comprising the set {Cᵢ} of optical systems (Cᵢ), the set {Aᵢ} of primary pixels (Aᵢ) and the set {Bᵢ} of secondary pixels (Bᵢ), in such a way that each optical system (Cᵢ) is likely to occupy:
- a first position in which the optical system (Cᵢ) simultaneously covers all of the primary sub-pixels (A_{iβ}) of one of the primary pixels (Aᵢ) and part of the secondary sub-pixels (B_{iβ}) of at least one of the adjacent secondary pixels (Bᵢ),
- a second position in which the optical system (Cᵢ) simultaneously covers all of the secondary sub-pixels (B_{iβ}) of one of the secondary pixels (Bᵢ) and part of the primary sub-pixels (A_{iβ}) of at least one of the adjacent primary pixels (Aᵢ), the predetermined sequence passing through a controlled variation between the first position and second position.

3. The optoelectronic device (10) according to claim 2, wherein each of the primary and secondary pixels (Aᵢ, Bᵢ) is likely to adopt a first light configuration in which all of the sub-pixels (A_{iβ}, B_{iβ}) which compose it, emit a light beam and wherein each optical system (Cᵢ) is likely to occupy either the first position when the primary pixel (Aᵢ) that it covers adopts the first light configuration, or the second position when the secondary pixel (Bᵢ) which it covers adopts the first light configuration.

4. The optoelectronic device (10) according to any of claims 2 or 3, wherein said at least one displacement mechanism (111) acts on at least one element selected from the group comprising the set {Ci} of optical systems (Cᵢ), the set {Ai} of primary pixels (Aᵢ) and the set {Bi} of secondary pixels (Bᵢ), in such a way that each optical system (Cᵢ) is likely to occupy a third position in which the optical system (Cᵢ) simultaneously covers part of the primary sub-pixels (A_{iβ}) of one of the primary pixels (Aᵢ) and part of the secondary sub-pixels (B_{iβ}) of at least one of the adjacent secondary pixels (Bᵢ), the predetermined sequence passing through a controlled variation between the first position, the second position and the third position.

5. The optoelectronic device (10) according to claim 4, wherein each of the primary and secondary pixels (Aᵢ, Bᵢ) is likely to adopt a second light configuration in which part of the sub-pixels (A_{iβ}, B_{iβ}) which compose it, emit a light beam and wherein each optical system (Cᵢ) is likely to occupy the third position when at least one of the primary pixels (Aᵢ) and at least one of the secondary pixels (Bᵢ) that it covers by occupying the third position simultaneously adopt the second light configuration, at least one of the primary sub-pixels (A_{iβ}) and at least one of the secondary sub-pixels (B_{iβ}) covered by the optical system (Cᵢ) occupying the third position emitting a light beam.

6. The optoelectronic device (10) according to claim 5, wherein the predetermined sequence provides a frequency f for the alternations between the first light configuration and the second light configuration, and for the displacements of each optical system (Cᵢ) of one among the first and second positions towards the third position, expressed in Hz, verifying the formula f≥24*n where n is the number of possible translational movements of the optical system (Cᵢ) by said at least one displacement mechanism (111).

7. The optoelectronic device (10) according to any of claims 1 to 6, wherein said at least one displacement mechanism (111) comprises piezoelectric actuators and/or micro-actuators such as piezoelectric materials and/or electroactive polymers and/or shape memory alloys and/or magnetic actuators.

8. The optoelectronic device (10) according to any one of claims 1 to 7, wherein each optical system (Cᵢ) comprises an optical lens configured so as to be traversed by at least part of the light beams likely to be emitted by the primary and secondary sub-pixels (A_{iβ}, B_{iβ}) which it covers while ensuring their optical transformation in order to emit at the output a transformed light beam at least in part made directional in a main direction (D1, D2).

9. The optoelectronic device (10) according to claim 8, wherein the optoelectronic device (10) comprises at least one collimation angle changing element (122) configured to act on at least one of the optical systems (Cᵢ) so as to selectively place its optical lens among a plurality of distinct optical configurations, the angle formed between the main direction (D1, D2) and the substrate (101) varying from one optical configuration to another optical configuration.

10. The optoelectronic device (10) according to claim 9, wherein the collimation angle changing element (122) comprises piezoelectric elements in the optical lens and/or micro actuators such as piezoelectric materials and/or electroactive polymers and/or shape memory alloys and/or magnetic actuators and/or actuatable liquid crystals that the optical lens incorporates.

11. The optoelectronic device (10) according to any of claims 9 or 10, wherein at least one among said at least one displacement mechanism (111) and said at least one collimation angle changing element (122) is configured to act on the optical system (Cᵢ) so that the optical system (Cᵢ) is displaced:
- at least in part transverse to the free surface (101a) of the substrate (101);
and/or
- at least in part generally parallel to the free surface (101a) of the substrate (101).

12. The optoelectronic device (10) according to any one of claims 1 to 11, wherein within the set {Ci} of optical systems (Cᵢ), all the optical systems (Cᵢ) are linked together so as to form a monolithic unitary assembly within which each optical system (Cᵢ) is fixed with respect to all the others optical systems (Cᵢ).

13. An image display system comprising:
- at least one optoelectronic device (10) according to claim 6 and any of claims 7 to 12,
- at least one graphic calculator (20) capable of calculating images to be displayed by the optoelectronic device (10) and transmitting said images to be displayed to the optoelectronic device (20),
the graphic calculator (20) being configured to calculate at least one set of images to be displayed successively comprising n+1 images to be successively displayed,
the set of images to be displayed successively comprising an image to be displayed comprising data relating to the set {Ai} of primary pixels (Aᵢ) and n images to be displayed comprising data relating to the n sets {Bi} of primary pixels (Bᵢ) corresponding to n displacements of the set {Ci} of optical systems (Cᵢ),
each image to be displayed being transmitted to the optoelectronic device (10) by the graphic calculator (20) synchronously with each displacement of the set {Ci} of optical systems (Cᵢ).

14. A method for controlling an optoelectronic device (10) configured to emit light, in particular to display images, or to capture light, wherein the optoelectronic device (10) comprises:
- at least one set {Ai} of primary pixels (Aᵢ) where each primary pixel (Aᵢ) is arranged on a free surface (101a) of a substrate (101) and comprises at least one primary sub-pixel (A_{iβ}) capable of emitting a primary light beam on the side opposite the substrate (101),
- at least one set {Bi} of secondary pixels (Bᵢ) where the secondary pixels (Bᵢ) are arranged on the free surface (101a) of the substrate (101) alternately with the primary pixels (Aᵢ) so that each primary pixel (Aᵢ) is adjacent to at least one secondary pixel (Bᵢ) and each secondary pixel (Bᵢ) comprises at least one secondary sub-pixel (B_{iβ}) capable of emitting a secondary light beam on the side opposite the substrate (101),
- a set {Ci} of optical systems (Cᵢ) where each optical system (Cᵢ) is arranged so as to be able to cover, on the side opposite to the substrate (101), both the entirety of a pixel (Aᵢ, Bᵢ) belonging to one of the sets ({Ai}, {Bi}) of pixels selected from the set {Aᵢ} of primary pixels (Aᵢ) and the set {Bi} of secondary pixels (Bᵢ) and at least part of the sub-pixels (A_{iβ}, B_{iβ}) of at least one of the adjacent pixels (Aᵢ, Bᵢ) belonging to the other of the sets ({Ai}, {Bi}) of pixels, each optical system (Cᵢ) being configured to act optically on all or part of the light beams likely to be emitted by the sub-pixels (A_{iβ}, B_{iβ}) belonging to the pixels (Aᵢ, Bᵢ) that it covers, the total number of pixels (Aᵢ, Bᵢ) of the sets ({Ai}, {Bi}) of primary and secondary pixels (Aᵢ, Bᵢ) being greater than or equal to twice the number of optical systems (Cᵢ) contained in the set {Ci} of optical systems (Cᵢ),
- at least one displacement mechanism (111) making it possible to apply a sequential relative movement between the set {Ci} of optical systems (Cᵢ) and the sets ({Ai}, {Bi}) of pixels (Aᵢ, Bᵢ) in a predetermined sequence,
the controlling method comprising, for the implementation of said predetermined sequence, a phase repeated periodically over time and comprising the following steps:
a) controlling said at least one displacement mechanism (111) in a manner allowing each optical system (Cᵢ) to be placed in a first position in which the optical system (Cᵢ) simultaneously covers all of the primary sub-pixels (A_{iβ}) of one of the primary pixels (Aᵢ) and part of the secondary sub-pixels (B_{iβ}) of at least one of the adjacent secondary pixels (Bᵢ) or in a second position in which the optical system (Cᵢ) simultaneously covers all of the secondary sub-pixels (B_{iβ}) of one of the secondary pixels (Bᵢ) and part of the primary sub-pixels (A_{iβ}) of at least one of the adjacent primary pixels (Aᵢ),
b) acting on the primary pixel (Aᵢ) or the secondary pixel (Bᵢ) of which all the sub-pixels (A_{iβ}, B_{iβ}) are covered by the optical system (Cᵢ) following step a) so as to place it in a first light configuration in which all of the sub-pixels (A_{iβ}, B_{iβ}) which compose it emit a light beam,
c) controlling said at least one displacement mechanism (111) in a manner allowing to displace each optical system (Cᵢ) to place it either in the second position if the optical system (Cᵢ) occupied the first position following step a), or in the first position if the optical system (Cᵢ) occupied the second position following step a), or in a third position in which the optical system (Cᵢ) simultaneously covers part of the primary sub-pixels (A_{iβ}) of one of the primary pixels (Aᵢ) and part of the secondary sub-pixels (B_{iβ}) of at least one adjacent secondary pixels (Bᵢ),
d) acting either on the primary pixel (Aᵢ) or the secondary pixel (Bᵢ) whose all the sub-pixels (A_{iβ}, B_{iβ}) are covered by the optical system (Cᵢ) following step c) so as to place it in the first light configuration in which all the sub-pixels (A_{iβ}, B_{iβ}) that compose it emit a light beam, or at the same time on at least one primary pixel (Aᵢ) whose primary sub-pixels (A_{iβ}) are covered by the optical system (Cᵢ) following step c) so as to place it in a second light configuration in which at least one of the primary sub-pixels (A_{iβ}) covered by the optical system (Cᵢ) emits a light beam and on at least one secondary pixel (Bᵢ) whose secondary sub-pixels (B_{iβ}) are covered by the optical system (Cᵢ) following step c) so as to place it in a second light configuration in which at least one of the secondary sub-pixels (B_{iβ}) covered by the optical system (Cᵢ) emits a light beam.

15. The controlling method according to claim 14, wherein each optical system (Cᵢ) comprises an optical lens configured so as to be traversed by at least part of the light beams likely to be emitted by the primary and secondary sub-pixels (A_{iβ}, B_{iβ}) which it covers while ensuring their optical transformation in order to emit at the output a transformed light beam at least in part made directional in a main direction (D1, D2) and wherein the optoelectronic device (10) comprises at least one collimation angle changing element (122) configured to act on at least one of the optical systems (Cᵢ) so as to selectively place its optical lens among a plurality of distinct optical configurations where the angle formed between the main direction (D1, D2) and the substrate (101) varies from one optical configuration to another optical configuration, the controlling method being such that the phase comprises a step e), implemented before step c), consisting in actuating the collimation angle changing element (122) so as to vary the angle formed between the main direction (D1, D2) and the substrate (101) at least once so as to place the optical lens successively in at least two distinct optical configurations.
